(19) 

**Europäisches Patentamt**
**European Patent Office**
**Office européen des brevets**

(11)  **EP 4 622 104 A1**

(12)  **EUROPEAN PATENT APPLICATION**

(43) Date of publication:
24.09.2025  Bulletin 2025/39

(21) Application number: 24382293.9

(22) Date of filing: **18.03.2024**

(51) International Patent Classification (IPC):
*H03F 5/00* (2006.01)  *H03F 19/00* (2006.01)

(52) Cooperative Patent Classification (CPC):
**H03F 19/00; H03F 5/00; H03F 7/04**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Consejo Superior de Investigaciones Científicas**
**(CSIC)**
**28006 Madrid (ES)**

(72) Inventors:
• **Ramos, Tomás**
**Madrid (ES)**
• **Porras, Diego**
**Madrid (ES)**
• **Gomez, Alvaro**
**Madrid (ES)**
• **García Ripol, Juan José**
**Madrid (ES)**
• **González Tudela, Alejandro**
**Madrid (ES)**

(74) Representative: **Pons IP**
**Glorieta Rubén Darío 4**
**28010 Madrid (ES)**

(54)  **A METHOD FOR STABILIZING NONLINEAR PARAMETRIC AMPLIFIER ARRAYS AND A SUPERCONDUCTING QUANTUM PARAMETRIC AMPLIFIER ARRAY**

(57)  Method for stabilizing a non-linear parametric amplifier array comprising N non-linear resonator modes, at sites $j$ = 1, ..., N, linear and non-linear couplings between sites, external coherent control fields on each site and input/output ports to send and retrieve an amplified signal; the method comprising: setting the phases of the external coherent control fields to grow linearly with site index, dividing the N sites of the array in 3 regions, setting, in the central region, an homogeneous steady-state solution, assuming periodic boundary conditions, and setting the central quantities to produce directional topological amplification in an homogenous system; in the left and right buffer regions, imposing to some quantities a smoothly increasing or decreasing profile function from the boundaries to the center; choosing external coherent control frequencies or bare resonator frequencies to locally compensate for the photon number-dependent frequency shifts induced by non-linearities; and solving the exact steady-state mean-field displacements assuming open boundary conditions.

EP 4 622 104 A1

**Description**

**OBJECT OF THE INVENTION**

The present invention relates to directional quantum amplifiers of microwave radiation. In particular, it is the object of the invention a method for controlling and stabilizing an array of non-linearly coupled parametric oscillators, as well as a design for implementing with this technique a stable directional, broadband, and on-chip superconducting quantum amplifier.

**BACKGROUND ART**

Quantum technologies promises to revolutionize our capacity to process information by exploiting physical principles of microscopic world: quantum superpositions and entanglement. In particular, one of the most powerful ideas currently under development is quantum computation, which consists in storing the "0" and "1" of the binary code in quantum systems such as atoms or solid-state materials and manipulating them perform computation algorithms much more efficient or even impossible for any classical device.

Among the many platforms that can implement quantum bits or "qubits" for quantum technologies and computation are superconducting devices, i.e. lowtemperature electronic circuits whose elemental excitations of charge and flux are quantized. Here, the key elements for realizing qubits are non-linear inductors typically in the form of Josephson junctions, which can be coupled to linear quantum LC circuits and microwave control lines for their manipulation.

In recent years, superconducting quantum technology has shown a great capacity to scale the number of qubits in a chip, reaching on the order of hundreds. However, scaling the number of qubits orders of magnitude further presents various technical limitations. Controlling increasingly larger quantum circuits demands a huge overhead in control and measurement lines (at least one of them per qubit), which incorporates heat, noise, and unwanted cross-talk to the device, limiting the time to maintain its quantum nature.

One of the biggest current bottlenecks is the measurement lines, which require bulky elements such as amplifiers and circulators to detect the weak quantum signals generated by each qubit. Therefore, a big challenge in the field is to build new quantum microwave amplifiers that can be integrated on-chip, while still providing large gain, low noise, large bandwidth, and isolation of the quantum source via an intrinsic directionality. One of the most advanced microwave quantum amplifiers so far are Josephson traveling-wave parametric amplifiers (JTWPA), which can reach large gain, large bandwidth, and near quantum-limited low noise, but they are not directional. Therefore, they require the addition of extra off-chip bulky elements such as isolators and circulators to render the amplifier effectively directional and protect the quantum source from noise coming from the amplifier. The large size of these off-chip elements currently limits the scalability of superconducting quantum information processors since cryogenic fridges to cool the system have limited volume.

In the state-of-the-art, directional amplification has only been done in narrow band quantum amplifiers such as Josephson parametric amplifiers (JPA). Therefore, on-chip quantum amplifying devices are currently either nondirectional or non-broadband. Broadband and directional amplification is crucial for implementing large-scale quantum information processors, where multiple signals need to be simultaneously detected without harming the qubits. Therefore, building such on-chip quantum amplifiers are highly desirable for developing the superconducting quantum technology.

Currently, there is a fast-growing industry producing and commercializing superconducting quantum hardware including companies doing full-stack superconducting quantum computers (Google, IBM, IQM, Rigetti, D-wave, etc) as well as other companies only focused on building specific components such as quantum amplifiers (QuantWare, Silent Waves, VTT, etc). Quantum computing is an emerging technology whose market is estimated to have reached USD Million 866 in 2023 and will reach 4375 in 2028, with potential applications in finance, engineering and chemistry.

**DESCRIPTION OF THE INVENTION**

The invention consists of a method for stabilizing a non-linear parametric amplifier array and a design for implementing with it a directional, broadband, and on-chip quantum parametric amplifier of microwave radiation.

The superconducting quantum amplifier is an arrangement of coupled microscopic elements built with superconducting circuits. Currently, several private companies commercialize or fabricate their own amplifiers for microwave radiation by using superconducting elements, although with a different scheme, typically based in JTWPAs or JPAs such as Silent Waves (France), VTT (Finland), and QuantWare (The Netherlands) in Europe. Therefore, there is a genuine interest in this technology and specially in upgrade it for performing directional and broadband quantum amplification.

The invention's novelty lies in the inhomogenous design of the array of superconducting elements and in the novel scheme for parametrically driving those superconducting elements, which allows for realizing a stable and directional on-chip amplifier with large gain, broad bandwidth and near quantum-limited noise.

As explained before, superconducting circuits are the leading quantum computing technology, thus, the present invention has a large potential for commercialization. Further potential benefits are in Astrophysics, where it can be used for detecting astronomical signals.

The technical problem that the invention solves is the on-chip parametric amplification of microwave radiation with a scheme that shows, at the same time, the following properties:

1. Large Gain. By "gain" we mean the factor by which the device can amplify the amplitude of the signal. For quantum applications with superconducting circuits gain needs to be typically on the order of 100 (or 20dB in the usual logarithmic scale).

2. Broadband. By "broadband" it is implied that radiation frequencies are amplified over a broad range of frequencies typically within 5 - 10 GHz (Gigahertz) for microwave parametric amplifiers.

3. Near quantum-limited noise. By "quantum-limited" it is implied that the signal-to-noise ratio is as large as allowed by the laws of Physics, which set a limit on a minimum level of noise that is created in any quantum device that acts as an amplifier.

4. Directional. By "directional" it is implied that signals propagating in a preferred direction (outwards the source) are amplified, whereas signals or noise propagating in the opposite direction (towards the source) are suppressed. As a very relevant practical consequence, the amplifier does not require external bulky isolator elements to protect the quantum source from the backward noise, strongly improving the miniaturization of the whole quantum computing device and thereby favoring scalability.

5. Robustness to fabrication imperfections and disorder, avoiding excess of gain "ripples" as a function of signal frequency.

6. No need for directional couplers. State-of-art superconducting parametric amplifiers require using a directional coupler to input the pump in the system and induce amplification of the signal while protecting the quantum source from the pump's reflection which typically is very strong. Directional couplers are also bulky external elements so getting rid of them can further improve on-chip miniaturization and improve size scalability of the whole device.

7. Stable. By "stable" it is implied that the operation of the amplifier can be stabilized over time so that its amplification can be realized.

None of the state-of-the-art is capable of solving all those issues at the same time.

The present invention relates to a method for stabilizing a non-linear parametric amplifier array for microwave radiation.

In the method of the invention the amplifier array is defined to comprise:

- N non-linear resonator modes, wherein each mode, located at site $j = 1, ..., N$, is represented by a local complex amplitude ($a_j(t)$), and is characterized by a bare frequency ( $\omega_b^j$ ), a quartic self-Kerr anharmonicity ( $K_s^j$ ), and a local decay rate ($\kappa_j$),

- linear couplings placed between neighboring sites (j) described by bare hopping rates ( $J_b^j$ ),

- non-linear couplings placed between neighboring sites described by quartic cross-Kerr interactions ( $K_c^j$ ), as well as by right- and left- photon-number-dependent hopping rates ($T_j$) and ( $T_j'$ ), respectively,

- external coherent control fields on each site (j), wherein each control field drive each resonator applying a waveform with strength ( $\Omega_p^j$ ), frequency ( $\omega_p^j$ ), and phase ( $\theta_p^j$ ); and

- input/output ports placed at specific sites (j = l) and (j = 0), configured to send a signal to amplify and to retrieve an amplified signal, respectively.

The method of the invention comprises steps for finding suitable inhomogeneous profiles for the control fields: $\Omega_p^j$, $\omega_p^j$, $\theta_p^j$ and/or array parameters: $\omega_b^j$, $\kappa_j$, $J_b^j$, $K_s^j$, $K_c^j$, $T_j$, $T_j'$, that give rise to a stable steady-state configuration of mean-field displacements and that is compatible with directional amplification of signals in the non-linear array. The condition of rising a stable steady-state configuration of mean-field displacements is equal to applying:

$$\langle a_j(t \to \infty)\rangle = \alpha_{ss}^j$$

For that, the method of the invention comprises the steps of:

- setting the phases of the external coherent control fields to grow linearly with site index, as:

$$\theta_p^j = \varphi j$$

with $\varphi \neq 0$, so that time-reversal symmetry in the array is broken;
- dividing the N sites of the array in 3 regions: left buffer region ($j \in [1, N_L]$), the central region ($j \in [N_L + 1, N_L + N_C]$), and right buffer region ($j \in [N - N_R + 1, N]$), such that $N = N_L + N_R + N_C$
- setting, in the central region, $\omega_b^j = \omega_b^C$, $\kappa_j = \kappa_C$, $J_b^j = J_b^C$, $K_s^j = K_s^C$, $K_c^j = K_c^C$, $T_j = T_C$, $T_j' = T_C'$, $\Omega_p^j = \Omega_p^C$, $\omega_p^j = \omega_p^C$, being each one a constant central quantity, looking for an homogeneous steady-state solution $\langle a_j(t \to \infty)\rangle = \alpha_{ss}^C$ in this region, assuming periodic boundary conditions, and setting the constant central quantities $\omega_b^C$, $\kappa_C$, $J_b^C, K_s^C, K_c^C$, $T_C$, $T_C', \Omega_p^C, \omega_p^C$, such that there would be directional topological amplification in an homogenous system;

- in the left and right buffer regions, determining one or more quantities $Q_j$ selected from the control strengths $\Omega_p^j$, the linear array quantities $\kappa_j$, $J_b^j$ or all the non-linear couplings $K_s^j, K_c^j$, $T_j$, $T_j'$, and imposing for them a smoothly increasing or decreasing profile function from the boundaries ($Q_1, Q_N$) to the locally homogeneous value at the central region $Q_C$ according to the relation,

$$\frac{Q_j}{Q_C} = f(j)$$

wherein the profile function $f(j)$ is positive and continuous for each j, tends to 1 in the central region and increases or decreases in the buffer regions;

- choosing the external coherent control frequencies $\omega_p^j$ or bare resonator frequencies $\omega_b^j$ to locally compensate for the photon number-dependent frequency shifts induced by the non-linearities $K_s^j, K_c^j$, $T_j$, $T_j'$, such that the effective detuning $\Delta_j$ between pump frequency and shifted resonator frequencies is homogeneous or nearly homogenous $\Delta_j \sim \Delta_C$ along the array; and

- solving the exact steady-state mean-field displacements $\langle a_j(t \to \infty)\rangle = \alpha_{ss}^j$ assuming open boundary conditions of the non-linear array.

Preferably, the step of setting the constant central quantities $\omega_b^C$, $\kappa_C$, $J_b^C, K_s^C, K_c^C$, $T_C$, $T_C', \Omega_p^C, \omega_p^C$ such that there would be directional topological amplification in an homogenous system is performed according to the method defined in the document: [RAMOS, Tomás et al. Directional Josephson traveling-wave parametric amplifier via non-Hermitian topology. DOI:10.48550/arXiv.2207.13728].

Also, the step of solving the steady-state mean-field displacements $\alpha_j = \langle a_j(t)\rangle$ could be determined by using a rotating wave approximation, which defines a non-linear system of equations, given by

$$\dot{\alpha}_j = -(\frac{\kappa_j}{2} - i\Delta_b^j)\alpha_j + \Omega_p^j e^{-i\theta_p^j} - i(J_b^j + T_j'|\alpha_j|^2 + \frac{T_j}{2}|\alpha_{j+1}|^2)\alpha_{j+1}$$

$$-i(J_b^{j-1} + T_{j-1}|\alpha_j|^2 + \frac{T_{j-1}'}{2}|\alpha_{j-1}|^2)\alpha_{j-1}$$

$$+iK_s^j|\alpha_j|^2\alpha_j + iK_c^j|\alpha_{j+1}|^2\alpha_j + iK_c^{j-1}|\alpha_{j-1}|^2\alpha_j$$

$$+i\frac{K_c^j}{2}\alpha_j^*\alpha_{j+1}^2 + i\frac{K_c^{j-1}}{2}\alpha_j^*\alpha_{j-1}^2 - i\frac{T_{j-1}}{2}\alpha_{j-1}^*\alpha_j^2 - i\frac{T_j'}{2}\alpha_{j+1}^*\alpha_j^2,$$

where $\Delta_b^j = \omega_p^j - \omega_b^j$ is the detuning between the pump frequency and the bare frequency of resonator at each site $j$.

Moreover, the step of calculating the profiles of the pump frequencies $\omega_p^j$ or the bare resonator frequencies $\omega_b^j$ to locally compensate for the photon number-dependent shifts could be obtained by the following steps:

- solving the differential equations of the step of step of solving the steady-state mean-field displacements, $\alpha_{ss}^j = \alpha_j(t \to \infty) = |\alpha_{ss}^j|e^{i\theta_{ss}^j}$ by setting $\dot{\alpha}_j = 0$ and imposing the condition that the bare detunings $\Delta_b^j$ relate to the effective detunings $\Delta_j = \omega_p^j - \omega_s^j$ between pump and shifted resonator frequencies $\omega_s^j$ as:

$$\Delta_b^j = \Delta_j - 2K_s^j|\alpha_{ss}^j|^2 - K_c^j|\alpha_{ss}^{j+1}|^2 - K_c^{j-1}|\alpha_{ss}^{j-1}|^2$$

$$+2|\alpha_{ss}^j|\cos(\varphi)\left[T_{j-1}|\alpha_{ss}^{j-1}| + T_j'|\alpha_{ss}^{j+1}|\right].$$

the resulting system of algebraic non-linear equations being:

$$(\kappa_j/2 - i\Delta_j)|\alpha_{ss}^j| - 2i\cos(\varphi)|\alpha_{ss}^j|^2(T_{j-1}|\alpha_{ss}^{j-1}| + T_j'|\alpha_{ss}^{j+1}|)$$

$$+2iK_s^j|\alpha_{ss}^j|^3 + iK_c^j|\alpha_{ss}^j||\alpha_{ss}^{j+1}|^2 + iK_c^{j-1}|\alpha_{ss}^j||\alpha_{ss}^{j-1}|^2$$

$$+ie^{-i\varphi}|\alpha_{ss}^{j+1}|(J_b^j + T_j'|\alpha_{ss}^j|^2 + \frac{T_j}{2}|\alpha_{ss}^{j+1}|^2)$$

$$+ie^{i\varphi}|\alpha_{ss}^{j-1}|(J_b^{j-1} + T_{j-1}|\alpha_{ss}^j|^2 + \frac{T_{j-1}'}{2}|\alpha_{ss}^{j-1}|^2)$$

$$-iK_s^j|\alpha_{ss}^j|^3 - iK_c^j|\alpha_{ss}^{j+1}|^2|\alpha_{ss}^j| - iK_c^{j-1}|\alpha_{ss}^{j-1}|^2|\alpha_{ss}^j|$$

$$-ie^{-2i\varphi}\frac{K_c^j}{2}|\alpha_{ss}^j||\alpha_{ss}^{j+1}|^2 - ie^{2i\varphi}\frac{K_c^{j-1}}{2}|\alpha_{ss}^j||\alpha_{ss}^{j-1}|^2$$

$$+ie^{-i\varphi}\frac{T_{j-1}}{2}|\alpha_{ss}^{j-1}||\alpha_{ss}^j|^2 + ie^{i\varphi}\frac{T_j'}{2}|\alpha_{ss}^{j+1}||\alpha_{ss}^j|^2 - \Omega_p^j = 0.$$

- setting the effective detuning $\Delta_j$ to be constant along the array, namely $\Delta_j = \Delta_C$, and solving the non-linear system of equations starting from the known locally homogeneous solution at the central region $|\alpha_{ss}^j| = |\alpha_{ss}^C|$, and iterating from there towards the boundaries, in the left buffer region, determining recursively $|\alpha_{ss}^{j-1}|$ given $|\alpha_{ss}^j|$ and $|\alpha_{ss}^{j+1}|$, whereas in the right buffer region, determining recursively $|\alpha_{ss}^{j+1}|$ given $|\alpha_{ss}^j|$ and $|\alpha_{ss}^{j-1}|$;

- using the resulting steady-state profile of the whole array to self-consistently determine the bare detuning $\Delta_b^j$ that leads to the effective constant detuning $\Delta_j = \Delta_C$, namely:

$$\Delta_b^j = \Delta_C - 2K_s^j |\alpha_{ss}^j|^2 - K_c^j |\alpha_{ss}^{j+1}|^2 - K_c^{j-1}|\alpha_{ss}^{j-1}|^2$$
$$+2|\alpha_{ss}^j| \cos(\varphi)\left[T_{j-1}|\alpha_{ss}^{j-1}| + T_j'|\alpha_{ss}^{j+1}|\right].$$

- determining the inhomgenous profile of one of $\omega_p^j$ or $\omega_b^j$ using $\Delta_b^j = \omega_p^j - \omega_b^j$ and taken the other as constant in the central region.

The step of calculating the steady-state displacement could also be simplified by approximating $|\alpha_{ss}^{j\pm1}| \approx |\alpha_{ss}^j|$ so that the algebraic system of non-linear equations is reduced to $N$ independent third-order equations for $|\alpha_{ss}^j|^2$, which read:

$$|K_s^j + Z_j - Y_j|^2 |\alpha_{ss}|^6 + 2\left\{\left[\frac{\kappa_j}{2} - \Im(X_j)\right]\Im(Y_j)\right.$$
$$-[\Delta_j - \Re(X_j)][K_s^j + Z_j - \Re(Y_j)]\}|\alpha_{ss}|^4$$
$$+\{[\kappa_j/2 - \Im(X_j)]^2 + [\Delta_j - \Re(X_j)]^2\}|\alpha_{ss}|^2 - (\Omega_p^j)^2 = 0.$$

wherein the coefficients $X_j$, $Y_j$, and $Z_j$ are defined as:

$$X_j = J_b^j e^{-i\varphi} + J_b^{j-1} e^{i\varphi},$$

$$Y_j = K_c^j(1 + e^{-2i\varphi}/2) + K_c^{j-1}(1 + e^{2i\varphi}/2)$$
$$-T_j e^{-i\varphi}/2 - T'_{j-1}e^{i\varphi}/2$$
$$-T_{j-1}\left(e^{i\varphi} + \frac{e^{-i\varphi}}{2}\right) - T'_j\left(e^{-i\varphi} + \frac{e^{i\varphi}}{2}\right),$$

$$Z_j = K_c^j + K_c^{j-1} - 2\cos(\varphi)(T'_j + T_{j-1}).$$

Preferably, in the step of imposing the relation between the quantities $Q_j$ calculated for the central region and the buffer regions, $f(j)$, a smoothly increasing function from the boundaries to the centre:

$$Q_j = Q_c f(j)$$

could be chosen, and the decreasing function would be the inverse of the same function:

$$Q_j = Q_c / f(j)$$

More preferably, the function $l(l)$ could be defined as:

$$f(j) = \begin{cases} \sin^2\left(\dfrac{\pi}{2}\dfrac{j}{(N_L + 1)}\right), & \text{if } 1 \le j \le N_L \\ 1, & \text{if } N_L + 1 \le j \le N - N_R \\ \sin^2\left(\dfrac{\pi}{2}\dfrac{(N + 1 - j)}{(N_R + 1)}\right), & \text{if } N - N_R + 1 \le j \le N \end{cases}$$

with $N_L$, $N_R \sim 2$ or $3$, $N_C \gg 1$.

In a preferred set of embodiments, when determining the homogeneous parameters $\omega_b^C$, $\kappa_C$, $J_b^C$, $K_s^C$, $K_c^C$, $T_C$, $T_C'$, $\Omega_p^C$, $\omega_p^C$ in the central region so that they lead to directional parametric amplification the following quantities could be set: $\varphi = \pi/2$, $\Delta_C = 0$, $J_b^C = 0$, $T_C = T_C' = \dfrac{K_s^C}{2} = K_c^C$, $\omega_b^C = \omega_p^C + 6|\alpha_C|^2 K_c^C$, $K_c^C = \dfrac{\kappa_C}{4|\alpha_C|^2}$, , with $\alpha_C$, $\kappa_C$, $\omega_p^C$ and $\Omega_p^C$ satisfying a standard 3rd order Duffing oscillator equation,

$$\left(\frac{\kappa_C}{2} - i\left[\left(\omega_p^C - \omega_b^C\right) + 3K_c^C|\alpha_c|^2\right]\right)\alpha_C = \Omega_p^C$$ .

The invention also relates to a superconducting quantum parametric amplifier array of microwave radiation.
The superconducting quantum parametric amplifier array of the invention comprises:

- $N$ non-linear LC circuits, wherein each of them, located at site $j = 1, ..., N$, comprises an on-site non-linear inductor of energy (Ej), with linear inductance ( $L_J^j$ ) and quartic Kerr non-linearity, and an on-site capacitance $C_j$, both placed in parallel and connected to ground;

- couplings between neighboring sites $j$ and $j + 1$ comprising an inter-site linear capacitance $\overline{C}_j$ and an inter-site non-linear inductor of energy ( $\overline{E}_J^j$ ), with linear inductance ( $\overline{L}_J^j$ ) and quartic Kerr nonlinearity, placed in parallel;

- external transmission lines connected via a capacitor $C_p^j$ to each node ($j$) configured to send coherent control fields; and

- external transmission lines connected to specific sites ($j = I$) and ($j = 0$), via capacitances $C_s^I$ and $C_s^O$ , configured to send microwave signals and to retrieve the amplified signals, respectively.

The superconducting quantum parametric amplifier array of the invention is configured such that the control fields and/or the circuit parameters have inhomogeneous amplitudes, frequencies and/or phases obtained by the method of the invention already defined.

Preferably, the on-site and inter-site non-linear inductors of energies ( $E_J^j$ ) and ( $\overline{E}_J^j$ ), respectively, can be selected from an array of Josephson junctions or a kinetic inductance material, such that they lead to linear inductances ( $L_J^j$ ) and ( $\overline{L}_J^j$ ), and quartic Kerr non-linearities, to leading order in the energy-flux relation.

More preferably, the on-site and inter-site non-linear inductors of energies ( $E_J^j$ ) and ( $\overline{E}_J^j$ ), can be selected from: single Josephson junctions (JJ), SQUIDs, Quartons in parallel to a linear inductance, SNAILS, or a sub-array of any of the former non-linear inductive elements in series, such that they lead to linear inductances ( $L_J^j$ ) and ( $\overline{L}_J^j$ ), and quartic Kerr non-linearities, to leading order in the energy-flux relation.
The superconducting quantum parametric amplifier array of the invention could further comprise two additional non-linear inductors of energies ( $\bar{E}_J^0$ ) and ( $\bar{E}_J^N$ ), with linear inductances ( $\bar{L}_J^0$ ) and ( $\bar{L}_J^N$ ) and quartic Kerr non-linearities, coupled to sites ($j = 1$) and ($j = N$), as well as two additional capacitances ($\overline{C}_0$) and ($\overline{C}_N$), on parallel to the respective inductor and connected to ground, to induce more homogeneous effective array parameters.

In a set of embodiments, the external transmission lines could have an impedance ( $Z_p^j$ ) and comprise each one a voltage generator ( $V_p^j$ ) configured to generate the coherent control pump signals of strength ( $\Omega_p^j$ ), frequency ( $\omega_p^j$ ), and phase ( $\theta_p^j$ ).

Alternatively, the external transmission lines could comprise an auxiliary waveguide comprising:

- *N* linear LC circuits, wherein each of them, located at site *j* = 1, ..., *N*, comprises an on-site linear inductance (Lw) and an on-site capacitance $C_w^j$ , both placed in parallel and connected to ground;

- linear auxiliary couplings between neighboring sites *j* and *j* + 1 comprising an inter-site capacitance $\bar{C}_w^j$ ; and
- external auxiliary transmission lines connected to the boundary sites (*j* = 1) and (*j* = *N*), via auxiliary capacitances $C_{wp}^I$ and $C_{wp}^O$ , configured to send a traveling coherent field at (*j* = 1) and to absorb at (*j* = *N*) without reflections by engineering perfect impedance matching conditions at the boundaries.

In another set of embodiments, the external transmission lines could comprise voltage generators ( $V_p^j$ ) connected to a first set of nodes (j), and the auxiliary waveguide connected to a second set of nodes (j).

In the superconducting quantum parametric amplifier array of the invention, the local dissipation $\kappa_j$ of each non-linear LC circuit could be realized either by the capacitor $C_p^j$ connected to each external transmission line or by on-chip resistors ($R_j$) placed in parallel to the on-site non-linear inductor of energy (Ej) and the on-site capacitance ($C_j$).

The variables defined in the method of the invention could be applied to multiple amplifier array arrangements.

In a preferred set of embodiments, the variables of the method of the invention are obtained from a specific arrangement of amplifier array defined as comprising:

- *N* non-linear LC circuits, wherein each of them, located at site *j* = 1, ..., *N*, comprises an on-site non-linear inductor of energy (Ej), with linear inductance ( $L_J^j$ ) and quartic Kerr non-linearity, and an on-site capacitance $C_j$, both placed in parallel and connected to ground, being each site represented by the local complex amplitude ($a_j(t)$), defined by its frequency ( $\omega_b^j$ ), self-Kerr quartic anharmonicity ( $K_s^j$ ) and local dissipation ($\kappa_j$);
- couplings, linear couplings and non-linear couplings, between neighboring sites *j* and *j* + 1 comprising an inter-site linear capacitance $\overline{C}_j$ and an inter-site non-linear inductor of energy ( $\bar{E}_J^j$ ) with linear inductance ( $\overline{L}_J^j$ ) and quartic Kerr non-linearity, placed in parallel, being each linear coupling defined by a nearest neighbor hopping ( $J_b^j$ ), and each non-linear coupling defined by a quartic cross-Kerr interaction ( $K_c^j$ ), as well as by right- and left- photon-number-dependent hopping rates ($T_j$) and ($T_j'$), respectively; and

- external transmission lines connected via a capacitor $C_p^j$ to each node (j) configured to send coherent control fields of strength ( $\Omega_p^j$ ), frequency ( $\omega_p^j$ ), and phase ( $\theta_p^j$ ).

**DESCRIPTION OF THE DRAWINGS**

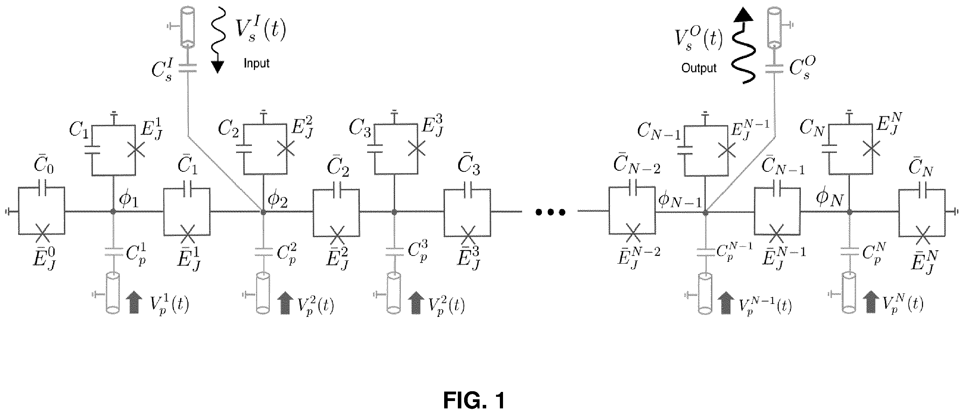

Figure 1 shows a superconducting circuit design for realizing a directional parametric amplifier array of $N$ sites with possibility for general inhomogeneous control fields and/or inhomogeneous circuit parameters. At each node $j$, flux and charge variables behave as quantum non-linear LC circuits with on-site capacitance $C_j$ and on-site non-linear inductors of energy $E_J^j$. These non-linear LC circuits implement non-linear quantum oscillator modes which couple to neighboring sites in the array via linear capacitances $\overline{C}_j$ and inter-site nonlinear inductors of energy $\overline{E}_J^j$. In addition, each node $j$ is connected via a capacitor $C_p^j$ to an external transmission line to send a coherent control pump. Finally, two sites m = $I, O$ are additionally connected via a capacitance $C_s^m$ to other transmission lines to send and retrieve amplified signals.

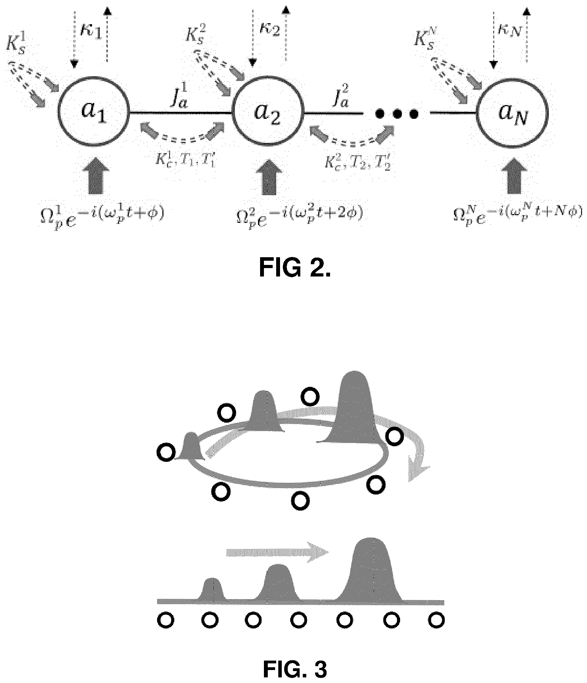

FIG 2. shows a representation of the model that the circuit in Figure 1 implements, consisting of an array of driven-dissipative non-linear parametric amplifiers. Here, the circles describe local oscillator modes $a_j(t)$ of frequency $\omega_b^j$, self-Kerr anharmonicities $K_s^j$, and local dissipation $\kappa_j$. These anharmonic modes are coupled to each other by nearest neighbour linear hopping terms $J_b^j$, non-linear cross-Kerr interactions $K_c^j$, as well as by right- and left-photon-number-dependent hopping rates $(T_j)$ and $(T_j')$, respectively. Finally, each of these modes is driven via the local pumps of strength $\Omega_p^j$, frequency $\omega_p^j$, and phase $\theta_p^j$ to induce four-wave mixing processes.

FIG. 3. Possible boundary conditions for an array of coupled non-linear parametric amplifiers as in Fig.2. Top panel: For closed (or periodic) boundary conditions the directional amplification is never stable. Bottom panel: For open boundary conditions, stable directional amplification only exist when the system parameters are not all homogeneous. Moreover, inhomogeneous profiles of the controls and/or system parameters must be engineered with specific criteria as in the method of the invention.

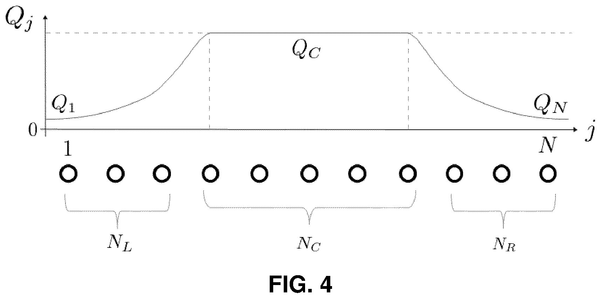

FIG. 4. Profile $Q_j$ of some inhomogeneous control or circuit parameters to reduce boundary effects due to the non-linear interactions in the amplifier array. It consists in separating the array in three regions: Left buffer region (L) of $N_L$ sites, central region of $N_c$ sites, and the right buffer region (R) of $N_R$ sites. On the left buffer region, some control or circuit parameter $Q_j$ must vary smoothly from $Q_1$, at the first site, towards the central region, where it remains constant with value $Q_C$ (up to imperfections). Finally, in the right buffer region, $Q_j$ varies smoothly from the central value $Q_C$ until it reaches $Q_N$ at the last site. The profile $Q_j$ will typically increase from the boundary towards the center ($Q_1, Q_N << Q_C$), but depending on the control parameter, it can also reduce from boundary to center ($Q_1, Q_N >> Q_C$).

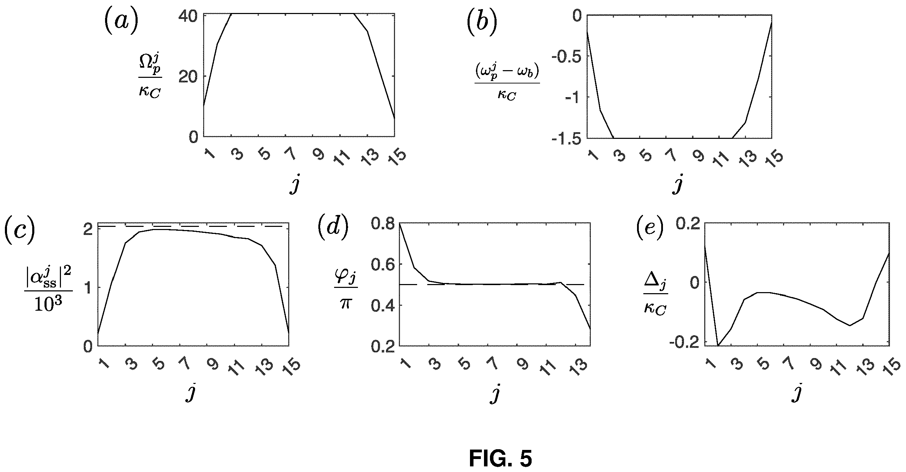

FIG. 5. Profiles for inhomogeneous configurations via external control parameters. (a) Inhomogeneous pump amplitudes $\Omega_p^j$ as a function of site index $j$. (b) Inhomogeneous local frequencies $\omega_p^j$ vs site index $j$. (c) Resulting inhomogeneous profile of mean resonator displacements $\left|\alpha_{ss}^j\right|^2$. The dashed line corresponds to $\left|\alpha_{ss}^j\right|^2 = \left|\alpha_{ss}^C\right|^2$. (d) Profile of phase differences $\varphi_j$ between neighboring sites as a function of site index $j$. The dashed line corresponds to $\varphi_j = \pi/2$. (d) Variation of effective detuning $\Delta_j/\kappa_C$ over the array.

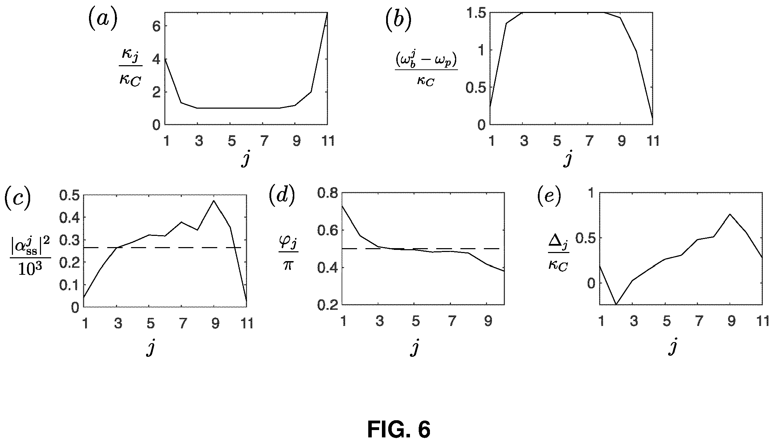

FIG. 6. Profiles for inhomogeneous configurations via circuit parameters. (a) Inhomogeneous antenna couplings $\kappa_j$ with respect to the central one $\kappa_c$ as a function of site index $j$. (b) Inhomogeneous local frequencies $\omega_b^j$ vs site index $j$.

(c) Resulting inhomogeneous profile of mean resonator displacements $\left|\alpha_{ss}^{j}\right|^2$. The dashed line corresponds to

$\left|\alpha_{ss}^{j}\right|^2 = \left|\alpha_{ss}^{C}\right|^2$. (d) Profile of phase differences $\varphi_j$ between neighboring sites as a function of site index $j$. The dashed line corresponds to $\varphi_j = \pi/2$. (e) Variation of effective detuning $\Delta_j/\kappa_C$ over the array vs site index $j$.

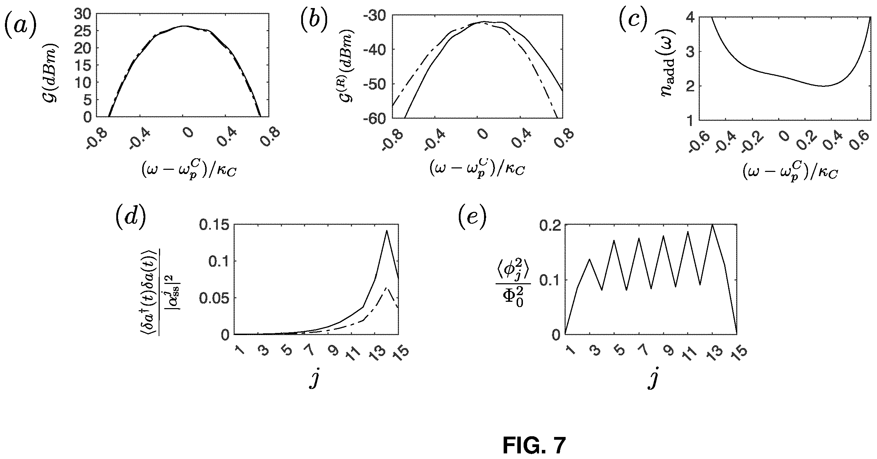

FIG. 7. Performance of the directional parametric amplifier array with an inhomogeneous configuration of external controls as shown in Fig.5. (a) Gain $G$ (in dBm) vs frequency of the signal field (solid) and the idler field (dashed). (b) Reverse gain $G^{(R)}$ (in dBm) vs frequency of the signal field (solid) and the idler field (dashed). (c) Added noise $n_{add}$ vs frequency. (d) Maximum occupation of fluctuation $\langle \delta a_j^\dagger \delta a_j \rangle$ normalized by the occupation of the mean-field displacement vs site index $j$. The Dashed line corresponds to the contribution only from the vacuum and the solid line includes the effect of the signal with an amplitude of $\Omega_c/\kappa_C = 0.28$. (e) Flux mean square $\langle \phi_j^2 \rangle$ normalized by the flux quantum squared $\Phi_0^2$ as a function of site index $j$. Notice that quantities in (d)-(e) are much smaller than 1, which justifies all the approximations of our theory.

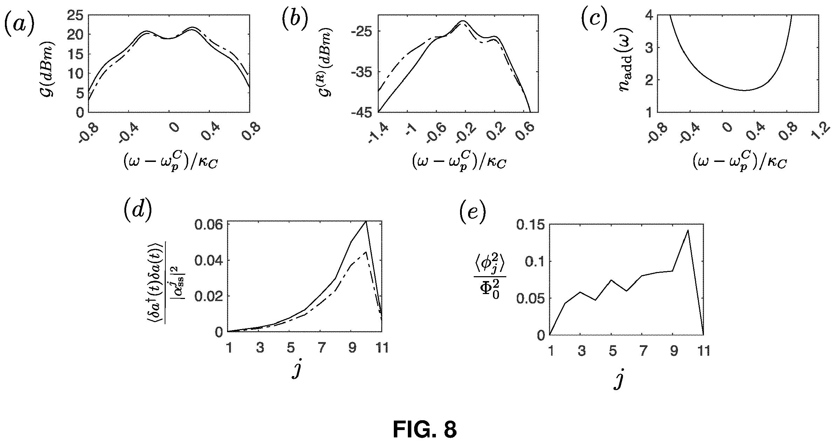

Fig. 8. Performance of the directional parametric amplifier array with an inhomogeneous configuration of circuit parameters as shown in Fig.6. (a) Gain $G$ (in dBm) vs frequency of the signal field (solid) and the idler field (dashed). (b) Reverse gain $G^{(R)}$ (in dBm) vs frequency of the signal field (solid) and the idler field (dashed). (c) Added noise $n_{add}$ vs frequency. (d) Maximum occupation of fluctuation $\langle \delta a_j^\dagger \delta a_j \rangle$ normalized by the occupation of the mean-field displacement vs site index $j$. The Dashed line corresponds to the contribution only from the vacuum and the solid line includes the effect of the signal with an amplitude of $\Omega_c/\kappa_C = 0.18$. (e) Flux mean square $\langle \phi_j^2 \rangle$ normalized by the flux quantum squared $\Phi_0^2$ as a function of site index $j$. Notice that quantities in (d)-(e) are much smaller than 1, which justifies all the approximations of our theory.

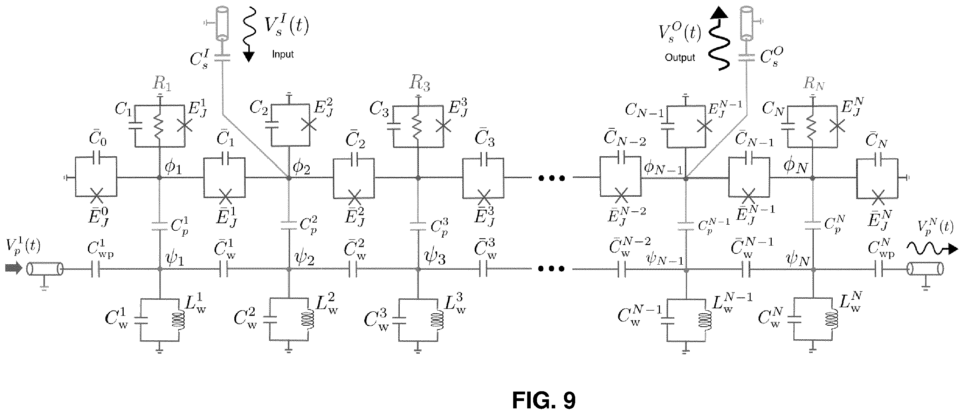

FIG. 9. Design of the directional parametric amplifier array with the pump distributed via an auxiliary waveguide and with local losses induced by on-chip resistors $R_j$.

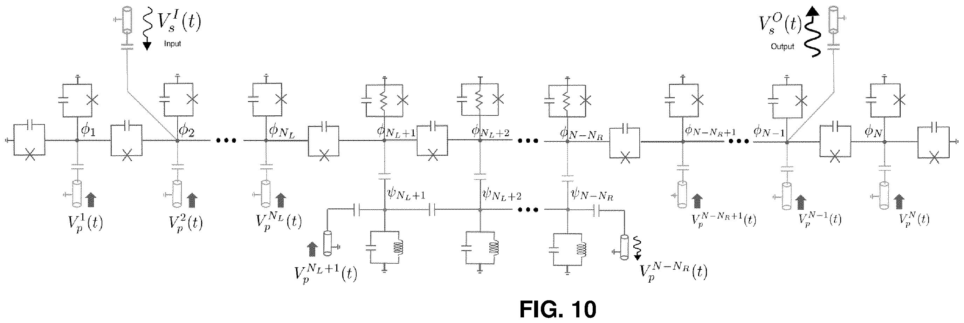

FIG. 10. Design of the directional parametric amplifier array coupled to an auxiliary waveguide in the central region ($N_L < j \leq N_L + N_c$), where the pump can have constant amplitude. On the left and right buffer regions, coupled to independent voltage generators ($V_p^j$) to tune an inhomogeneous profile of the controls. Local dissipation is induced by the external transmission lines at the left and right buffer regions while this is induced by local on-chip resistors $R_j$ in the central region.

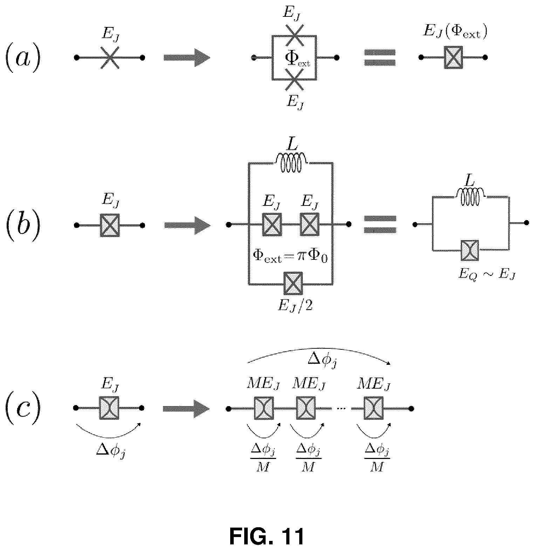

FIG. 11. Alternative improvements for the non-linear inductors of amplifier setup. (a) Two JJs on parallel to achieve a flux-tunable JJ. (b) Quarton nonlinearity in parallel to a linear inductor $L$ to achieve larger Kerr nonlinearities $K_s$ and $K_c$. (c) Sub-array of $M$ identical non-linearities (standard JJs, SQUIDs, Quartons, etc) in series to reduce the phase drop over elements and thereby reduce photon saturation of the device.

## PREFERRED EMBODIMENTS OF THE INVENTION

## Superconducting circuit model

The superconducting circuit to realize a stable directional amplifier array with superconductig circuits is shown in Fig. 1.

At each node $j$ = 1, ..., $N$, independent flux variables $\phi_j(t)$ are defined, which locally behave as weakly anharmonic transmons due an on-site non-linear inductor of energy $E_J^j$ with linear inductance ($L_J^j$) and quartic Kerr non-linearity, shunted by an on-site capacitance $C_j$. Each of these transmons couples to its neighbors via a capacitance $\overline{C}_j$ and an inter-

site non-linear inductor of energy $\bar{E}_J^j$, with linear inductance ($\bar{L}_J^j$) and quartic Kerr non-linearity. The most direct way to realize these non-linear inductors is by using Josephson junctions (JJ), in which case $E_J^j$ and $\bar{E}_J^j$ are the Josephson energies of on-site and inter-site non-linear inductors, and the linear Josephson inductances read $L_J^j = \frac{\Phi_0^2}{E_J^j}, \bar{L}_J^j = \frac{\Phi_0^2}{\bar{E}_J^j}$. Here, $\Phi_0 = \hbar/(2e)$ is the flux quantum with $\hbar$ the reduced Planck's constant and e the electron's charge (constants of nature).

In the following, a model using JJ non-linearities is formulated in detailed. After this, it will be also shown how to generalize this model to account for SQUID non-linearities, Quarton non-linearities, and also sub-arrays of any of these non-linearities in series to reduce saturation effects.

The Lagrangian $L_{JJ}$ describing the dynamics of the system in the case of JJ non-linearities reads,

$$L_{JJ} = \sum_{j=1}^N \frac{c_j}{2}(\dot{\phi}_j)^2 + \sum_{j=0}^N \frac{\bar{c}_j}{2}(\dot{\phi}_{j+1} - \dot{\phi}_j)^2 \qquad (1)$$

$$+ \sum_{j=1}^N E_J^j \cos\left(\frac{\phi_j}{\Phi_0}\right) + \sum_{j=0}^N \bar{E}_J^j \cos\left(\frac{\phi_{j+1}-\phi_j}{\Phi_0}\right).$$

Note that inter-site capacitances $\bar{C}_0$ and $\bar{C}_N$ were also included, as well as inter-site Josephson energies $\bar{E}_J^0$ and $\bar{E}_J^N$, which couple on the boundaries to $\phi_1$ and $\phi_N$, respectively.

This does not add extra dynamical variables as both ends of the array are coupled to ground, implying $\phi_0 = \phi_{N+1} = 0$ as boundary conditions.

To externally control the transmons, each node $j$ = 1, ... , $N$ is coupled via a with capacitance $C_p^j$ to an independent transmission line of impedance $Z_p^j$, as shown in Fig. 1.

In this way, each transmon locally interacts with an external voltage $V_p^j(t)$, which will be used to send a coherent pump and to induce local dissipation via its quantum vacuum fluctuations. The Lagrangian $L_p$ of the control part of the circuit reads

$$L_p = \sum_{j=1}^N \frac{c_p^j}{2}(\dot{\phi}_j - V_p^j(t))^2. \qquad (2)$$

Finally, two extra transmission lines of impedance $Z_s^j$ are added at fixed sites $j = I$ and $j = O$ in order to send signals and retrieve the amplified signals, respectively.

These dedicated lines allow to separate the channels of the pumps and signal, protecting the quantum source from the reflection of the pump. In the context of the present invention this can be done in the setup without using directional couplers and having no isolators, thanks to the directionality of the amplifier defined in the present invention. This reduces considerably the need for external bulky elements to operate the amplifier reliably and enables a full on-chip integration of all the elements required in a quantum pre-amplification stage at ~ 10mK temperatures, improving scalability.

The Lagrangian $L_s$ describing the capacitive coupling to these dedicated input/output lines reads

$$L_s = \sum_{m=I,O} \frac{c_s^m}{2}(\dot{\phi}_m - V_s^m(t))^2, \qquad (3)$$

where $V_s^m(t)$ are the external voltages at the input ($m = I$) and output ($m = 0$) signal lines, respectively, whereas $C_s^m$ are the corresponding capacitive couplings. Usually the values for the variables are $I = 2$ and $0 = N - 1$ as in Fig. 1, but in the design, the values stablished were for any $I < 0 = 1, ... , N$.

A standard canonical quantization procedure can now be applied to the circuit with total Lagrangian $L = L_{JJ} + L_p + L_s$.

First, the classical canonical charge $q_j$ of the circuit is determined, which is given by:

$$q_j = \frac{\partial L}{\partial \dot{\phi}_j} = C_{eq}^j \dot{\phi}_j - \bar{C}_{j-1} \dot{\phi}_{j-1} - \bar{C}_j \dot{\phi}_{j+1} - C_p^j V_p^j(t) -$$

$$\delta_{Ij} C_s^I V_s^I(t) - \delta_{Oj} C_s^O V_s^O(t) \tag{4}$$

with $j = 1, ... , N$. Here, $\delta_{jl}$ denotes the Kronecker delta and the equivalent total capacitance $C_j^{eq}$ at site $j$ reads:

$$C_{eq}^j = C_j + \bar{C}_{j-1} + \bar{C}_j + C_p^j + \delta_{jI} C_s^I + \delta_{jO} C_s^O. \tag{5}$$

Using this expression for $q_j$ the total Hamiltonian of the system can be determined by a standard Legendre transformation, $H = \Sigma_j q_j \dot{\phi}_j - L$.

It is instructive to decompose the resulting Hamiltonian as $H = H_{JJ} + H_{TR}$ where $H_{JJ}$ is associated with the JJ array and $H_{TR}$ to the coupling to transmission lines.

These Hamiltonians in the limit of low coupling capacitances $\bar{C}_j$, $C_p^j, C_s^j \ll C_{eq}^j$ take the form:

$$H_{JJ} = \sum_{j=1}^{N} \frac{1}{2C_{eq}^j} q_j^2 + \sum_{j=1}^{N-1} \frac{\bar{C}_j}{C_{eq}^j C_{eq}^{j+1}} q_j q_{j+1} \tag{6}$$

$$- \sum_{j=1}^{N} E_J^j \cos\left(\frac{\phi_j}{\Phi_0}\right) - \sum_{j=0}^{N} \bar{E}_J^j \cos\left(\frac{\phi_{j+1} - \phi_j}{\Phi_0}\right),$$

$$H_{TR} = \sum_{j=1}^{N} \frac{C_p^j}{C_{eq}^j} q_j V_p^j(t) + \sum_{m=I,O} \frac{C_s^m}{C_{eq}^m} q_m V_s^m(t). \tag{7}$$

Notice that in $H_{TR}$ the terms $\sim (V_p^j)^2, (V_s^m)^2$ were omitted as these do not couple dynamical variables of the JJ array.

**Quantum description as driven-dissipative non-linear resonator array**

Since the Hamiltonians are now expressed only in terms of conjugate dynamical variables $\phi_j$ and $q_j$, one can apply the standard quantization procedure to Hamiltonian, which consists in promoting flux $\phi_j$ and charge $q_j$ variables to operators that satisfy canonical commutation relations, namely $[\phi_j, q_l] = i\hbar\delta_{jl}$, for $j, l = 1, ... , N$. Note that in Eq. (6) one has $\phi_0 = \phi_{N+1} = 0$ so they are not dynamical variables (and have no associated charge).

The next step is to consider the limit of low flux in all nodes of the JJ array, i.e. $\langle \phi_j^2 \rangle \ll \Phi_0^2$ such that it is a good approximation to expand the cosine potentials in Eq. (6) as $\cos(x) = 1 - x^2/2 + x^4/24 + O(x^6)$. In this way, the Hamiltonian of the JJ array up to the fourth order in the flux reads

$$H_{\mathrm{JJ}} = \sum_{j=1}^{N} \frac{1}{2c_{eq}^{j}} q_j^2 + \sum_{j=1}^{N-1} \frac{\bar{c}_j}{c_{eq}^{j} c_{eq}^{j+1}} q_j q_{j+1} \tag{8}$$

$$+ \sum_{j=1}^{N} \frac{1}{2L_{eq}^{j}} \phi_j^2 - \sum_{j=1}^{N-1} \frac{1}{\bar{L}_j^{j}} \phi_j \phi_{j+1}$$

$$- \sum_{j=1}^{N} \frac{(E_j^j + \bar{E}_j^j + \bar{E}_j^{j-1})}{24(\Phi_0)^4} \phi_j^4 - \sum_{j=1}^{N-1} \frac{\bar{E}_j^j}{4(\Phi_0)^4} \phi_{j+1}^2 \phi_j^2$$

$$+ \sum_{j=1}^{N-1} \frac{\bar{E}_j^j}{6(\Phi_0)^4} \left( \phi_{j+1}^3 \phi_j + \phi_{j+1} \phi_j^3 \right) + O(\phi_j^6),$$

where $L_j^j = (\Phi_0)^2 / E_j^j$ and $\bar{L}_j^j = (\Phi_0)^2 / \bar{E}_j^j$ are the Josephson inductances from on-site and inter-site JJs, respectively. Using these definitions, the inverse of the equivalent inductance at node $j$ of the circuit reads

$$1/L_{eq}^{j} = 1/L_j^{j} + 1/\bar{L}_j^{j} + 1/\bar{L}_j^{j-1}. \tag{9}$$

The quadratic local part $\widetilde{H}_{\mathrm{JJ}} = (1/2) \sum_{j=1}^{N} \left( q_j^2 / C_{eq}^{j} + \phi_j^2 / L_{eq}^{j} \right)$ in Eq. (8) can be diagonalized using the standard quantum harmonic oscillator procedure as $\widetilde{H}_{\mathrm{JJ}} = \sum_{j=1}^{N} \hbar \widetilde{\omega}_b^{j} a_j^{\dagger} a_j$. This is physically interpreted as $N$ independent quantum harmonic oscillator modes, one at each site $j$ which oscillates with bare frequency:

$$\widetilde{\omega}_b^{j} = 1/\sqrt{L_{eq}^{j} C_{eq}^{j}}. \tag{10}$$

At each of these local modes, microwave photons can be created and destroyed by applying creation and annihilation operations denoted by $a_j^{\dagger}$ and $a_j$, respectively. These operators satisfy canonical commutation relations $[a_j, a_l^{\dagger}] = \delta_{jl}$. Importantly, one can express flux $\phi_j$ and charge $q_j$ operators in terms of $a_j$ and $a_j^{\dagger}$ operators, obtaining

$$\phi_j = \sqrt{\frac{\hbar Z_j}{2}} (a_j^{\dagger} + a_j), \tag{11}$$

$$q_j = i \sqrt{\frac{\hbar}{2Z_j}} (a_j^{\dagger} - a_j), \tag{12}$$

where the effective circuit impedance at site $j$ reads

$$Z_j = \sqrt{L_{eq}^{j} / C_{eq}^{j}}. \tag{13}$$

From Eqs. (11)-(12) it can be noticed that the terms in Eq. (8) not included in $\tilde{H}_{\mathrm{JJ}}$ induce linear and non-linear couplings between the different local modes $a_j$. To see this explicitly, one replaces Eqs. (11)-(12) into $H_{\mathrm{JJ}}$, obtaining an array of coupled non-linear quantum oscillators,

$$\frac{H_{JJ}}{\hbar} = \sum_{j=1}^{N} \widetilde{\omega}_b^j a_j^\dagger a_j - \sum_{j=1}^{N-1} J_L^j (a_{j+1} + a_{j+1}^\dagger)(a_j + a_j^\dagger)$$

$$- \sum_{j=1}^{N-1} J_C^j (a_{j+1} - a_{j+1}^\dagger)(a_j - a_j^\dagger) - \sum_{j=1}^{N} \frac{K_s^j}{12} (a_j + a_j^\dagger)^4$$

$$- \sum_{j=1}^{N-1} \frac{K_c^j}{4} (a_j + a_j^\dagger)^2 (a_{j+1} + a_{j+1}^\dagger)^2,$$

$$+ \sum_{j=1}^{N-1} \frac{T_j}{6} (a_{j+1} + a_{j+1}^\dagger)^3 (a_j + a_j^\dagger)$$

$$+ \sum_{j=1}^{N-1} \frac{T_j'}{6} (a_j + a_j^\dagger)^3 (a_{j+1} + a_{j+1}^\dagger). \tag{14}$$

Here, the linear couplings $J_L^j$ and $J_C^j$, as well as the non-linear self-Kerr and cross-Kerr couplings $K_s^j$, $T_j$, and $T_j'$ read:

$$J_C^j = \frac{\bar{C}_j (Z_j Z_{j+1})^{-1/2}}{2 c_{eq}^j c_{eq}^{j+1}} = \frac{\sqrt{\widetilde{\omega}_b^j \widetilde{\omega}_b^{j+1}}}{2} \frac{\bar{C}_j}{\sqrt{c_{eq}^j c_{eq}^{j+1}}}, \tag{15}$$

$$J_L^j = \frac{(Z_j Z_{j+1})^{1/2}}{2 \bar{L}_J^j} = \frac{\sqrt{\widetilde{\omega}_b^j \widetilde{\omega}_b^{j+1}}}{2} \frac{\sqrt{L_{eq}^j L_{eq}^{j+1}}}{\bar{L}_J^j}, \tag{16}$$

$$K_c^j = \frac{\hbar \bar{E}_J^j}{4(\Phi_0)^4} Z_j Z_{j+1}, \tag{17}$$

$$K_s^j = \frac{\hbar (E_J^j + \bar{E}_J^{j-1} + \bar{E}_J^j)}{8(\Phi_0)^4} (Z_j)^2, \tag{18}$$

$$T_j = \frac{\hbar \bar{E}_J^j}{4(\Phi_0)^4} \sqrt{Z_j Z_{j+1}^3}, \tag{19}$$

$$T_j' = \frac{\hbar \bar{E}_J^j}{4(\Phi_0)^4} \sqrt{Z_j^3 Z_{j+1}}. \tag{20}$$

To simplify the problem it is convenient to consider the rotating wave approximation (RWA), and neglect all highly off-resonant processes provided all couplings are much smaller than the oscillator resonant frequencies, i.e. $J_L^j, J_C^j, K_s^j, K_c^j, T_j, T_j' \ll \widetilde{\omega}_b^j$. As a result, one obtains:

$$\frac{H_{JJ}}{\hbar} = \sum_{j=1}^{N} \omega_b^j a_j^\dagger a_j + \sum_{j=1}^{N-1} J_b^j (a_{j+1}^\dagger a_j + a_j^\dagger a_{j+1}) \tag{21}$$

$$- \sum_{j=1}^{N} \frac{K_s^j}{2} a_j^\dagger a_j^\dagger a_j a_j - \sum_{j=1}^{N-1} K_c^j a_{j+1}^\dagger a_{j+1} a_j^\dagger a_j,$$

$$- \sum_{j=1}^{N-1} \frac{K_c^j}{4} (a_{j+1}^\dagger a_{j+1}^\dagger a_j a_j + a_j^\dagger a_j^\dagger a_{j+1} a_{j+1})$$

$$+ \sum_{j=1}^{N-1} \frac{T_j}{2} (a_{j+1}^\dagger a_{j+1}^\dagger a_{j+1} a_j + a_j^\dagger a_{j+1}^\dagger a_{j+1} a_{j+1})$$

$$+ \sum_{j=1}^{N-1} \frac{T_j'}{2} (a_j^\dagger a_j^\dagger a_j a_{j+1} + a_{j+1}^\dagger a_j^\dagger a_j a_j),$$

where the local transition frequencies $\omega_b^j$ include small renormalization shifts due to the Kerr couplings:

$$\omega_b^j = \widetilde{\omega}_b^j - K_s^j - (K_c^j + K_c^{j-1})/2, \tag{22}$$

and the total linear couplings $J_b^j$ include capacitive, inductive, and cross-Kerr shifts:

$$J_b^j = J_C^j - J_L^j + (T_j + T_j')/2. \tag{23}$$

To drive and control each local mode $a_j$ of the array, a specific sinusoidal voltage pump $V_p^j(t)$ is applied on each transmission line $j = 1, \ldots, N$. One of the keys for stabilizing the amplifier is to allow these controls to have inhomogeneous amplitudes $A_p^j$, frequencies $\omega_p^j$, and phases $\theta_p^j$. The external voltage operator applied to each site then takes the form:

$$V_p^j(t) = A_p^j \cos(\omega_p^j t + \theta_p^j) + \delta V_p^j, \quad j = 1, \ldots, N, \tag{24}$$

where $\delta V_p^j$ is the operator describing quantum fluctuations of voltage at each line. Similarly, the voltage operators at the dedicated signal lines read:

$$V_s^m(t) = A_s \delta_{mI} \cos(\omega_s t + \theta_s) + \delta V_s^m, \quad m = I, O, \tag{25}$$

where $\delta V_s^m$ are the quantum fluctuations on the input ($m = I$) and output ($m = 0$) signal lines. Only the input signal port includes a classical sinusoidal waveform that describes the signal to be amplified with amplitude $A_s$, phase $\theta_s$, and frequency $w_s$. The voltage amplitudes $A_p^j$ and $A_s$ are related to the average source power $P_p^j$ and $P_s$ as

$$A_p^j = \sqrt{2Z_p^j P_p^j}, \tag{26}$$

$$A_s = \sqrt{2Z_s^I P_s}, \tag{27}$$

where $Z_p^j$ and $Z_s^j$ are the impedances of the pump and signal external transmission lines. The source power of pumps and signal can also be expressed in terms of the injected photon number per unit time $|\alpha_p^j|^2$ and $|\alpha_s|^2$, respectively, taking the form

$$P_p^j = \hbar\omega_p^j|\alpha_p^j|^2, \tag{28}$$

$$P_s = \hbar\omega_s|\alpha_s|^2. \tag{29}$$

To understand the effects of dissipation and emission of amplified microwave radiation into the transmission lines, it is instructive to further separate the TR Hamiltonian as $H_{TR} = H_p + H_s + H_{diss}$, where $H_p$ and $H_s$ describe the effect of the classical controls for pumps and signal, respectively, whereas $H_{diss}$ describes the dissipation into the lines. Starting from Eq. (7) and using Eqs. (12), (24), and (25), one obtains for the classical control the following two Hamiltonians describing coherent drives of all local modes $a_j$, namely:

$$\frac{H_p}{\hbar} = 2i\sum_{j=1}^N \Omega_p^j \cos(\omega_p^j t + \theta_p^j)(a_j^\dagger - a_j) \tag{30}$$

$$\approx i\sum_{j=1}^N \Omega_p^j(e^{-i(\omega_p^j t + \theta_p^j)}a_j^\dagger - e^{i(\omega_p^j t + \theta_p^j)}a_j) \tag{31}$$

$$\frac{H_s}{\hbar} = 2i\Omega_s \cos(\omega_s t + \theta_s)(a_I^\dagger - a_I) \tag{32}$$

$$\approx i\Omega_s(e^{-i(\omega_s t + \theta_s)}a_I^\dagger - e^{i(\omega_s t + \theta_s)}a_I), \tag{33}$$

where in Eqs. (31) and (33) the rotating wave approximation is applied once again, provided the driving strengths are much smaller than the pump, signal, and local transition frequencies, namely $\Omega_p^j, \Omega_s \ll \omega_p^j$, $\omega_s$, $\omega_0^j$. These driving strengths for pump and signal read:

$$\Omega_p^j = \frac{c_p^j}{2c_{eq}^j}\frac{A_p^j}{\sqrt{2\hbar Z_j}} = \frac{c_p^j}{2c_{eq}^j}\sqrt{\frac{Z_p^j}{Z_j}\frac{P_p^j}{\hbar}}, \tag{34}$$

$$\Omega_s = \frac{c_s^I}{2c_{eq}^I}\frac{A_s}{\sqrt{2\hbar Z_I}} = \frac{c_s^I}{2c_{eq}^I}\sqrt{\frac{Z_s^I}{Z_I}\frac{P_s}{\hbar}}. \tag{35}$$

Regarding the Hamiltonian describing dissipation, one can formally write it as:

$$H_{diss} = \sum_{j=1}^N \frac{c_p^j}{c_{eq}^j}q_j\delta V_p^j + \sum_{m=I,O}\frac{c_s^m}{c_{eq}^m}q_m\delta V_s^m. \tag{36}$$

Using the standard quantum description of the transmission line, the quantum fluctuation operators $\delta V_p^j$ and $\delta V_s^m$ can be also expressed in terms of creation/annihilation operators, which create/destroy excitations of microwave frequency $\omega$ propagating in the pump or signal transmission lines, respectively.

These operators are denoted as $f_j(\omega)$ and $d_m(\omega)$ for pump lines at site $j$ and signal lines at sites $m = I, O$, respectively. These operators satisfy continuum canonical commutation relations, $[f_j(\omega), f_{j'}^\dagger(\omega')] = (\delta_{jj'}\delta(\omega - \omega'), [d_m(\omega),$

$d_m,^\dagger(\omega')] = \delta_{mm'}\delta(\omega - \omega')$, and $[d_m(\omega), f_j(\omega')] = 0$, with $\delta(\omega - \omega')$ the Dirac delta function. In terms of these operators, and assuming a semiinfinite transmission line, the quantum voltage fluctuations at pump channels $j$ and signal channels $m = I, O$ read:

$$\delta V_p^j = i \int d\omega \sqrt{\frac{\hbar\omega Z_p^j}{4\pi}} (f_j^{\dagger}(\omega) - f_j(\omega)), \qquad (37)$$

$$\delta V_s^m = i \int d\omega \sqrt{\frac{\hbar\omega Z_s^m}{4\pi}} (d_m^{\dagger}(\omega) - d_m(\omega)). \qquad (38)$$

Considering the quantum system composed of JJ array and controls $H_{JJ} + H_c$ and the interaction with the environment represented by the $H_{diss}$ with quantum fluctuations (37)-(38), one can apply standard input-output theory to describe the circuit as an open quantum system in the Markov approximation. This approximation requires the coupling to the environment to be weak compared to the free transition energies.

Following the standard procedure, the quantum Langevin equations describing the coherent and dissipative processes taking place in the amplifier device read:

$$\dot{a}_j = \frac{i}{\hbar} [H_{JJ} + H_p + H_s, a_j] - \frac{\kappa_j}{2} a_j + \sqrt{\kappa_p^j} \tilde{f}_{in}^j(t)$$

$$+ \sum_{m=I,O} \sqrt{\kappa_s^m} \delta_{jm} \tilde{d}_{in}^m(t). \qquad (39)$$

Here, the $\kappa_p^j$ and $\kappa_s^m$ describe the decay rate of the local modes $a_j$ into microwave excitations in the pump and signal transmission lines, respectively.

In terms of the circuit parameters they read,

$$\kappa_p^j = \left(\frac{c_p^j}{2c_{eq}^j}\right)^2 \left(\frac{z_p^j}{z_j}\right) \omega_b^j, \qquad (40)$$

$$\kappa_s^m = \left(\frac{c_s^m}{2c_{eq}^m}\right)^2 \left(\frac{z_s^m}{z_m}\right) \omega_b^m. \qquad (41)$$

In addition, notice that $\kappa_j$ describes the total decay rate of mode $a_j$ into all possible channels, namely

$$\kappa_j = \kappa_p^j + \kappa_s^I \delta_{Ij} + \kappa_s^O \delta_{Oj}$$.

It has to be noted that input operators $\tilde{f}_{in}^j(t)$ and $\tilde{d}_{in}^m(t)$ describe the effect of quantum noise fluctuations entering the amplifier array via each pump channel $j$ and signal channel $m = I, O$, which is non-zero even if these channels are in vacuum at zero temperature. The output fields $\tilde{f}_{out}^j(t)$ and $\tilde{d}_{out}^m(t)$ describe the emission of microwave excitations in the outward direction of each pump channel $j$ and signal channel $m$. They are related to the input operators and the local modes $a_j$ of the amplifier by standard input-output relations:

$$\tilde{f}_{out}^j(t) = \tilde{f}_{in}^j(t) - \sqrt{\kappa_p^j} a_j(t), \quad j = 1, \dots, N, \qquad (42)$$

$$\tilde{d}_{out}^m(t) = \tilde{d}_{in}^m(t) - \sqrt{\kappa_s^m} a_m(t), \quad m = I, O. \qquad (43)$$

Input and output operators also satisfy canonical commutation relations

$$[\tilde{f}^{j}_{in/out}(t), \tilde{f}^{j'}_{in/out}{}^{\dagger}(t')] = \delta_{jj'}\delta(t-t')$$ and $$[\tilde{d}^{m}_{in/out}(t), \tilde{d}^{m'}_{in/out}{}^{\dagger}(t')] = \delta_{mm'}\delta(t-t').$$

Describing the response of the amplifier is simpler when applying a displacement transformation on the noise operators at the signal input/output ports $\tilde{d}^{m}_{in/out}(t)$, so that the effect of the coherent drive $H_s$ is absorbed in the new noise operators as:

$$\bar{d}^{m}_{in/out}(t) = \tilde{d}^{m}_{in/out}(t) + \delta_{mI}\frac{\Omega_s}{\sqrt{\kappa^I_s}}e^{-i\omega_s t}e^{-i\theta_s}. \tag{44}$$

The equivalent equations of motion and the input-output relations can then be recast as:

$$\dot{a}_j = \frac{i}{\hbar}[H_{JJ} + H_p, a_j] - \frac{\kappa_j}{2}a_j + \sqrt{\kappa^j_p}\tilde{f}^{j}_{in}(t) + \sum_{m=I,O}\sqrt{\kappa^m_s}\delta_{jm}\bar{d}^{m}_{in}(t), \tag{45}$$

$$\tilde{f}^{j}_{out}(t) = \tilde{f}^{j}_{in}(t) - \sqrt{\kappa^j_p}a_j(t), \quad j = 1,\dots,N, \tag{46}$$

$$\bar{d}^{m}_{out}(t) = \bar{d}^{m}_{in}(t) - \sqrt{\kappa^m_s}a_m(t), \quad m = I, O. \tag{47}$$

The dynamics given by Eqs. (45)-(47) for the Hamiltonian $H_{JJ}$ in Eq.(21) and $H_p$ in Eq.(31) demonstrate that the superconducting circuit device introduced in Fig. 1 realizes a an array of driven-dissipative non-linear parametric amplifiers. This is schematically depicted in Fig. 2, where the circles describe local oscillator modes with complex amplitudes $a_j(t)$, frequency $\omega^j_b$, self-Kerr anharmonicities $K^j_s$ and total local dissipation $\kappa_j$ coming from the coupling to the transmission lines. These anharmonic modes are coupled to each other via nearest neighbor linear hopping terms $J^j_b$ and non-linear cross-Kerr terms $K^j_c$. Finally, each of these modes is driven via the local pumps of strength $\Omega^j_p$, frequency $\omega^j_p$, and phase $\theta^j_p$ to induce four-wave mixing processes. Here, the self- and cross-Kerr nonlinearities of the JJ array are used to convert two pump excitations of frequency $\omega^j_p$ into signal and idler excitations of frequencies $\omega_s$ and $2\omega^j_p - \omega_s$, respectively.

**Four-wave mixing**

The superconducting circuit of the invention shown in Fig. 1 can work as a directional parametric amplifier array. To do so it requires parametric terms obtained from four-wave mixing processes but the origin of the amplification is fundamentally different compared to previous standard methods (such as JPAs and JTWPAs). The underlying topology of the amplifier array and the breaking of time-reversal symmetry by the phases of the external coherent pump is what induces the directionality of the amplification as well as all other remarkable features summarized in the description of the invention.

To perform four-wave mixing on each mode $a_j$, a strong coherent pump is considered on all $N$ sites, namely $\Omega^j_p \gg \kappa_j, |\Delta^j_b|$, where:

$$\Delta_b^j = \omega_p^j - \omega_b^j, \tag{48}$$

is the detuning between the pump and local transition frequency at site $j$. In this case, each mode at site $j$ is well described via a displacement transformation:

$$a_j = (\alpha_j + \delta\tilde{a}_j)e^{-i\omega_p^j t}, \tag{49}$$

where the coherent component $\alpha_j$ is highly populated compared to the small quantum fluctuation around it, i.e. $\langle\delta\tilde{a}_j^\dagger \delta\tilde{a}_j\rangle \ll |\alpha_j|^2$. Using the decomposition (49) in Eq.(39) one can derive a system of classical non-linear equations for $\alpha_j(t)$, as well as quantum Langevin equations for the quantum fluctuations $\delta\tilde{a}_j(t)$ describing an effective linear dynamics provided $\langle\delta\tilde{a}_j^\dagger \delta\tilde{a}_j\rangle/|\alpha_j|^2 \ll 1$.

On the one hand, the non-linear set of coupled equations for the mean displacements $\alpha_j$ take the form:

$$\dot{\alpha}_j = -(\frac{\kappa_j}{2} - i\Delta_b^j)\alpha_j + \Omega_p^j e^{-i\theta_p^j} - i(J_b^j + T_j'|\alpha_j|^2 + \frac{T_j}{2}|\alpha_{j+1}|^2)\alpha_{j+1}$$

$$-i(J_b^{j-1} + T_{j-1}|\alpha_j|^2 + \frac{T_{j-1}'}{2}|\alpha_{j-1}|^2)\alpha_{j-1}$$

$$+iK_s^j|\alpha_j|^2\alpha_j + iK_c^j|\alpha_{j+1}|^2\alpha_j + iK_c^{j-1}|\alpha_{j-1}|^2\alpha_j$$

$$+i\frac{K_c^j}{2}\alpha_j^*\alpha_{j+1}^2 + i\frac{K_c^{j-1}}{2}\alpha_j^*\alpha_{j-1}^2 - i\frac{T_{j-1}}{2}\alpha_{j-1}^*\alpha_j^2 - i\frac{T_j'}{2}\alpha_{j+1}^*\alpha_j^2. \tag{50}$$

Equations (50) can be numerically integrated in time via standard methods, such as Runge-Kutta.

However, not all solutions are compatible with directional amplification. The method for controlling amplification of microwave radiation of the invention introduces a criterium to induce a stable steady-state configuration that is compatible with directional amplification in this device.

This steady-state configuration corresponds to a solution $\alpha_{ss}^j = \alpha_j(t \to \infty)$ at which the mean displacement converges at long times. For convenience, the steady-state displacements at each site are decomposed in modulus and phase, namely $\alpha_{ss}^j = |\alpha_{ss}^j|e^{-i\theta_{ss}^j}$.

The effective dynamics for the quantum fluctuation $\delta a_j$ is obtained by linearizing the response around the mean steady-state displacements $\alpha_{ss} = |\alpha_{ss}^j|e^{-i\theta_{ss}^j}$, and therefore it is strongly determined by them.

In particular, obtaining the appropriate phases $\theta_{ss}^j \approx \varphi j$, growing linearly with position, is crucial for breaking time-reversal symmetry and thereby induce a steady-state manifesting directional amplification. However, it is equally crucial to have the appropriate steady-state amplitudes $|\alpha_j^{ss}|$ in order to stabilize the directional amplifier phase. Provided $|\alpha_j^{ss}|^2 \gg \langle\delta\tilde{a}_j^\dagger \delta\tilde{a}_j\rangle$, the dynamics for the quantum fluctuations can be linearized, obtaining:

$$\delta\dot{a}_j = i[\frac{H_{pa}}{\hbar}, \delta a_j] - \frac{\kappa_j}{2}\delta a_j + \sqrt{\kappa_p^j}\delta f_{in}^j(t) + \sum_{m=I,O}\sqrt{\kappa_s^m}\delta_{jm}d_{in}^m(t) \tag{51}$$

where the effective quadratic parametric amplifier Hamiltonian $H_{pa}$ reads,

$$\frac{H_{pa}}{\hbar} = -\sum_{j=1}^{N} \Delta_j \delta a_j^\dagger \delta a_j + \sum_{j=1}^{N-1} J_j e^{-i\varphi_j} (\delta a_{j+1}^\dagger \delta a_j + \text{h.c.})$$

$$-\sum_{j=1}^{N-1} (g_c^j \delta a_{j+1}^\dagger \delta a_j^\dagger + \text{h.c.})$$

$$-\sum_{j=1}^{N} (\frac{g_s^j}{2} \delta a_j^\dagger \delta a_j^\dagger + \text{h.c.}) + O(|\alpha_j|\delta a_j^3). \qquad (52)$$

Notice that Eqs.(51)-(52) are expressed in terms of the re-defined quantum fluctuation operators, $\delta a_j = \delta \tilde{a}_j e^{i\theta_{ss}^j}$, and quantum noise operators $f_{in}^j(t) = e^{i(\omega_p^j t + \theta_{ss}^j)} \tilde{f}_{in}^j(t)$, $d_{in}^m(t) = e^{i(\omega_p^m t + \theta_{ss}^m)} \bar{d}_{in}^m(t)$, so that only the phase differences between neighboring sites:

$$\varphi_j = \theta_{ss}^{j+1} - \theta_{ss}^j, \qquad (53)$$

appear explicitly in the equations. These are the physically relevant phase quantities that appear, for instance, as complex phases in the hopping term $J_j$ in Eq.(52).

In addition, one also obtains effective detunings $\Delta_j$ as well as local and non-local parametric driving terms $g_s^j$ and $g_c^j$. All these coefficients depend on the circuit parameters as well as on the steady-state amplitudes $|\alpha_{ss}^j|$ and phase differences $\varphi_j$. Explicitly, they are given by

$$\Delta_j = \Delta_b^j + 2K_s^j|\alpha_{ss}^j|^2 + K_c^j|\alpha_{ss}^{j+1}|^2 + K_c^{j-1}|\alpha_{ss}^{j-1}|^2$$

$$-2|\alpha_{ss}^j|[T_{j-1}|\alpha_{ss}^{j-1}|\cos(\varphi_{j-1}) + T_j'|\alpha_{ss}^{j+1}|\cos(\varphi_j)], \qquad (54)$$

$$J_j = J_b^j - 2K_c^j|\alpha_{ss}^j||\alpha_{ss}^{j+1}|\cos(\varphi_j) + T_j|\alpha_{ss}^{j+1}|^2 + T_j'|\alpha_{ss}^j|^2, \qquad (55)$$

$$g_c^j = K_c^j|\alpha_{ss}^{j+1}||\alpha_{ss}^j| - \frac{T_j}{2}|\alpha_{ss}^{j+1}|^2 e^{-i\varphi_j} - \frac{T_j'}{2}|\alpha_{ss}^j|^2 e^{i\varphi_j}, \qquad (56)$$

$$g_s^j = K_s^j|\alpha_{ss}^j|^2 + \frac{K_c^j}{2}|\alpha_{ss}^{j+1}|^2 e^{-2i\varphi_j} + \frac{K_c^{j-1}}{2}|\alpha_{ss}^{j-1}|^2 e^{2i\varphi_{j-1}}$$

$$-T_{j-1}|\alpha_{ss}^j||\alpha_{ss}^{j-1}|e^{i\varphi_{j-1}} - T_j'|\alpha_{ss}^j||\alpha_{ss}^{j+1}|e^{-i\varphi_j}. \qquad (57)$$

**Fully homogeneous configuration does not lead to stable directional amplifying steady state**

The simplest case to consider is when all effective quantities entering the effective Hamiltonian $H_{pa}$, are homogeneous, i.e. phase differences $\varphi_j = \varphi$, detunings $\Delta_j = \Delta$, decay rates $\kappa_j = \kappa$, hoppings $J_j = J$, and parametric couplings $g_c^j = g_c, g_c^j = g_c$. This, in turn, requires that it should exist a steady state solution of the nonlinear equations (50) with homogeneous amplitudes $|\alpha_{ss}^j|^2 = |\alpha_{ss}|^2$ and linearly increasing phase $\theta_{ss}^j = \varphi j$, for $j = 1, ..., N$.

To achieve the latter in an actual device, it has been tried to imprint the linearly increasing phase in steady-state by choosing $\theta_p^j = \varphi j$ in pump's phases, and to induce a homogeneous steady state $|\alpha_{ss}|$ by having all controls and circuit parameters homogeneous, i.e. homogeneous pump amplitudes $\Omega_p^j = \Omega_p$ , pump frequencies $\omega_p^j = \omega_p$ , and all

effective detunings and couplings $\Delta^j = \Delta$, $J_b^j = J_b$, $K_s^j = K_s$, $K_c^j = T_j = T_j' = K_c$ . Nevertheless, as it is shown in the following, stable directional amplifying steady-state solutions do not exist in a fully homogenous configuration of a device such as in Figs. 1 and 2 and therefore the amplifier could not be realized.

This is because of boundary effects. The only way that a fully homogenous solution of Eqs.(50) can exist is for a device in a closed loop configuration, as shown in Fig.3 (top panel), where site $j = 1$ connects to site $j = N$. However, it is known that this solution is unstable since fluctuations grow indefinitely, $\langle \delta a_j^\dagger \delta a_j \rangle \to \infty$ for $t \to \infty$.

The method of the invention allows to properly treating these boundary effects and finding a truly stable steady-state amplifier configuration in an open chain, as the one shown in Fig. 3 (bottom panel).

To look for steady-state solutions, $\dot\alpha_j = 0$ is set on the left-hand side of Eq.(50). In addition, it is imposed an homogeneous condition by using a plane-wave ansatz:

$$\alpha_{ss}^j = |\alpha_{ss}|e^{-i\varphi j}. \tag{58}$$

Thus, obtaining a set of $N$ independent nonlinear algebraic equations:

$$\{\kappa_j/2 - \Im(X_j) + \Im(Y_j)|\alpha_{ss}|^2 \tag{59}$$

$$-i[\Delta_b^j - \Re(X_j) + (K_s^j + \Re(Y_j))]|\alpha_{ss}|^2)]\}|\alpha_{ss}|e^{-i\varphi j}$$

$$= \Omega_p^j e^{-i\theta_p^j}.$$

First, it has to be noted that setting $\theta_p^j = \varphi j$ allows to imprint this same phase on the steady-state solution since this global phase can be canceled at both sides of all equations.

Thus, there are $N$ equations for the unique amplitude $|\alpha_{ss}|$, all of which need to be simultaneously satisfied. The coefficients $X_j$ and $Y_j$ in Eqs.(59) depend on linear hopping and non-linear cross-Kerr couplings, respectively, and are given by:

$$X_j = J_b^j e^{-i\varphi} + J_b^{j-1} e^{i\varphi}, \tag{60}$$

$$Y_j = K_c^j(1 + e^{-2i\varphi}/2) + K_c^{j-1}(1 + e^{2i\varphi}/2)$$

$$-T_j e^{-i\varphi}/2 - T_{j-1}' e^{i\varphi}/2$$

$$-T_{j-1}(e^{i\varphi} + e^{-i\varphi}/2) - T_j'(e^{-i\varphi} + e^{i\varphi}/2). \tag{61}$$

The solution $|\alpha_{ss}|$ should be compatible with specific values of effective detunings $\Delta_j$ that enter in the linear dynamics (51) for the quantum fluctuations.

Using the ansatz (58) in Eq.(54), it is obtained $\Delta_j = \Delta_b^j + 2K_s^j + Z_j|\alpha_{ss}|^2$ , where:

$$Z_j = K_c^j + K_c^{j-1} - 2\cos(\varphi)(T_j' + T_{j-1}). \tag{62}$$

To account for this self-consistently, it is replaced $\Delta_b^j$ in Eq.(59) by:

$$\Delta_b^j = \Delta_j - 2K_s^j |\alpha_{ss}|^2 - Z_j |\alpha_{ss}|^2. \tag{63}$$

Finally, the resulting equations are squared and manipulated to obtain $N$ third-order equations for $|\alpha_{ss}|^2$, namely:

$$|K_s^j + Z_j - Y_j|^2 |\alpha_{ss}|^6 + 2\{[\kappa_j/2 - \Im(X_j)]\Im(Y_j) \tag{64}$$
$$-[\Delta_j - \Re(X_j)][K_s^j + Z_j - \Re(Y_j)]\}|\alpha_{ss}|^4$$
$$+\{[\kappa_j/2 - \Im(X_j)]^2 + [\Delta_j - \Re(X_j)]^2\}|\alpha_{ss}|^2 - (\Omega_p^j)^2 = 0.$$

Once they are solved, it is determined $\Delta_b^j$ via Eq.(63) self-consistently.

In a fully homogeneous case, all pump controls and all circuit quantities are equal. Using this assumption in the general Eq.(64), one is left with three different non-linear equations for the displacement amplitude $|\alpha_{ss}|$ and they must be simultaneously satisfied for the plane wave ansatz (58) to be a true steady state solution. The three equations read

$$|K_s + Z_j - Y_j|^2 |\alpha_{ss}|^6 + 2\{[\kappa/2 - \Im(X_j)]\Im(Y_j) \tag{65}$$
$$-[\Delta - \Re(X_j)][K_s + Z_j - \Re(Y_j)]\}|\alpha_{ss}|^4$$
$$+\{[\kappa/2 - \Im(X_j)]^2 + [\Delta - \Re(X_j)]^2\}|\alpha_{ss}|^2 - (\Omega_p)^2 = 0.$$

where the coefficients $X_j$, $Y_j$ and $Z_j$ take three different values depending they are evaluated at the left boundary $j = 1$, right boundary $j = N$, or in the central region $1 < j < N$. Explicitly they are given by:

$$X_j = J_b \begin{cases} e^{-i\varphi}, & \text{if } j = 1 \\ 2\cos(\varphi), & \text{if } 1 < j < N \\ e^{i\varphi}, & \text{if } j = N \end{cases}, \tag{66}$$

$$Y_j = K_c \begin{cases} 1 + e^{-2i\varphi}/2 - 3e^{-i\varphi}/2 - e^{i\varphi}/2, & \text{if } j = 1 \\ 2 + \cos(2\varphi) - 4\cos(\varphi), & \text{if } 1 < j < N \\ 1 + e^{2i\varphi}/2 - 3e^{i\varphi}/2 - e^{-i\varphi}/2, & \text{if } j = N \end{cases}, \tag{67}$$

$$Z_j = K_c[1 - 2\cos(\varphi)] \begin{cases} 1, & \text{if } j = 1 \\ 2, & \text{if } 1 < j < N \\ 1, & \text{if } j = N \end{cases}. \tag{68}$$

The three different values of these coefficients come from the fact that sites in the "central" region have two neighbors, while sites at the "boundary" only have one neighbor.

Consequently, the three Eqs.(65) can only be simultaneously satisfied when $J_b = K_c = 0$, however, in that case, $J = g_c = 0$ and thus the sites of the amplifier array are all uncoupled. In that case, the steady-state could be stable, but it would behave as $N$ independent or disconnected parameteric amplifiers, being impossible to transmit the signal via the array and achieve directional amplification.

Therefore, the only way that all equations (65) are equal is to have a closed loop configuration, i.e. periodic boundary conditions in the system instead of an open chain configuration. In this case, all sites have two neighbors, including $j = 1$ and $j = N$ as they would be next to each other. When this is the case the homogeneous solution exists but as commented above, in this case, the directional amplifying steady state is unstable as the number of photons grows without limit.

Consequently, it is concluded that a stable configuration of the amplifier array must have open boundaries and be inhomogeneous either in the controls or/and in the circuit parameters.

**Method for stabilizing a directional amplifying steady state by engineering an inhomogeneous configuration or control and/or circuit parameters**

In the following, the method of the invention to solve the problem and find stable steady states for directional amplification in the setup of Figs. 1 and 2 is summarized. It consists of the following steps:

1. Consider the possibility for a fully inhomogeneous solution, including amplitude and phase:

$$\alpha_{ss}^j = |\alpha_{ss}^j| e^{-i\theta_{ss}^j}. \tag{69}$$

2. Choose the pump phases as $\theta_p^s = \varphi j$ with $\varphi \neq 0$. With this, the phases of $\alpha_{ss}^j$ will be given by $\theta_{ss}^j \approx \varphi j$ and time-reversal symmetry will be broken along the array due to the presence of the privileged direction in which $\theta_{ss}^j$ grows.

3. Divide the array of $N$ sites into three regions: (i) left buffer region of $N_L$ sites, for $1 \leq j \leq N_L$, (ii) the central region of $N_C$ sites, for $N_L + 1 \leq j \leq N_L + N_C$, and (iii) the right buffer region of $N_R$ sites, for $N - N_R + 1 \leq j \leq N$, with the total number of sites, $N = N_L + N_C + N_R$. At the central region, all pump controls and circuit quantities are homogeneous (up to disorder in fabrication), and on the left and right buffer regions, some control or circuit quantity represented generically as $Q_j$ should vary smoothly along the array (in a controlled way). See Fig. 4 for a sketch of the situation.

4. At the central region, take all pump controls and circuit parameters constant with values denoted by $\Omega_p^C, \omega_p^C, \omega_b^C, J_b^C, K_s^C, K_c^C$, $\kappa_C$. To estimate the nearly homogeneous steady state solution in this region, $|\alpha_{ss}^j|^2 \approx |\alpha_{ss}^C|^2$, use Eq. (65) for the values $X_C$, $Y_C$, and $Z_C$ evaluated at the middle of the central region (assuming it has two equal neighbors). Solving this unique third-order nonlinear equation, one obtains $|\alpha_{ss}^C|^2$, which can be replaced in Eqs.(54)-(57) to obtain all the effective parameters of the amplifier that are targeted at the center, namely $\Delta_C$, $J_C$, $g_c^C$, and $g_s^C$. These effective central parameters should be chosen such that the dynamics of quantum fluctuations $\delta a_j(t)$ in Eqs. (51) induce directional amplification as if the system were homogeneous, obtained preferably according to the method defined in the document: [RAMOS, Tomás et al. Directional Josephson traveling-wave parametric amplifier via non-Hermitian topology. DOI:10.48550/arXiv.2207.13728]. This occurs, for instance, for $|\Delta_C| = 0$, $J_C = \frac{\kappa_C}{2}, g_c^C = g_s^C = \frac{\kappa_C}{4}, \varphi = \frac{\pi}{2}$, and for any other value that the Greens's function, defined below in Eq.(78), has an exponential dependence in position as in Eq.(99).

5. At the buffer regions, select a quantity $Q_j$ either from the pump controls or from the circuit parameters and design it to vary smoothly in position $j$ from the constant value at the central region $Q_C$ to much smaller (or larger) values at the boundaries, namely $Q_1, Q_N \ll Q_C$ (or $Q_1, Q_N \gg Q_C$). Whether $Q_j$ should increase or decrease towards the boundaries will depend on the specific inhomogenous parameter that is chosen, which should lead to a solution of $|\alpha_{ss}^j|^2$ that is lower in the boundaries than in the center.
For convenience, define $Q_j/Q_C = f(j)$, where $f(j)$ is a dimensionless, positive, and continuous function of the site index $j$. At the central region, this profile function is constant and normalized, namely $f(j) = 1$.

$$f(j) = \begin{cases} \sin^2\left(\frac{\pi}{2}\frac{j}{(N_L+1)}\right), & \text{if } 1 \le j \le N_L \\ 1, & \text{if } N_L + 1 \le j \le N - N_R \\ \sin^2\left(\frac{\pi}{2}\frac{(N+1-j)}{(N_R+1)}\right), & \text{if } N - N_R + 1 \le j \le N \end{cases}. \qquad (70)$$

Using this function it is also possible to define a $Q_j$ quantity that smoothly increases from the center to the boundaries by setting $Q_j/Q_C = 1/f(j)$. Examples of $Q_j$ can be the pump amplitudes $\Omega_p^j$, which need to be increased from the boundaries to the center so that so $|\alpha_{ss}^j|^2$ also increase from boundaries to center. It is less practical to change the circuit parameters but this can also be possible. For instance, one could change the local decays $\kappa_j$, which need to be reduced from the boundaries to the center so that $|\alpha_{ss}^j|^2$ increases from boundary to center. Moreover, it is also possible to change nonlinearities $K_c^j$ and $K_s^j$ (which would need to be changed in the same proportion and increasing from boundaries to center).

6. In addition to changing a parameter $Q_j$ such as $\Omega_p^j$, $\kappa_j$ or $K_c^j$ and $K_s^j$, stabilizing the directional amplification steady state also requires ensuring that the effective detuning $\Delta_j$ of the linearized dynamics (51) is constant or nearly constant over the whole array, i.e. $\Delta_j \sim \Delta_C$. Since $\Delta_j$ depends non-linearly on the values $|\alpha_{ss}^j|^2$, it is thus also required to vary the bare detuning $\Delta_b^j$ either by changing the pump frequency $\omega_p^j$ or the array bare frequency $\omega_b^j$. To estimate what values of $\Delta_b^j$ one needs to choose at the buffer regions, two methods can be used:

(i) The most exact method consists in solving for the steady state of Eq.(50) condition on Eq.(54), using the inhomogeneous ansatz (69). From these assumptions, the set of $N$ coupled equations to solve read,

$$(\kappa_j/2 - i\Delta_j)|\alpha_{ss}^j| - 2i\cos(\varphi)|\alpha_{ss}^j|^2(T_{j-1}|\alpha_{ss}^{j-1}| + T'_j|\alpha_{ss}^{j+1}|)$$

$$+2iK_s^j|\alpha_{ss}^j|^3 + iK_c^j|\alpha_{ss}^j||\alpha_{ss}^{j+1}|^2 + iK_c^{j-1}|\alpha_{ss}^j||\alpha_{ss}^{j-1}|^2$$

$$+ie^{-i\varphi}|\alpha_{ss}^{j+1}|(J_b^j + T'_j|\alpha_{ss}^j|^2 + \frac{T_j}{2}|\alpha_{ss}^{j+1}|^2)$$

$$+ie^{i\varphi}|\alpha_{ss}^{j-1}|(J_b^{j-1} + T_{j-1}|\alpha_{ss}^j|^2 + \frac{T'_{j-1}}{2}|\alpha_{ss}^{j-1}|^2)$$

$$-iK_s^j|\alpha_{ss}^j|^3 - iK_c^j|\alpha_{ss}^{j+1}|^2|\alpha_{ss}^j| - iK_c^{j-1}|\alpha_{ss}^{j-1}|^2|\alpha_{ss}^j|$$

$$-ie^{-2i\varphi}\frac{K_c^j}{2}|\alpha_{ss}^j||\alpha_{ss}^{j+1}|^2 - ie^{2i\varphi}\frac{K_c^{j-1}}{2}|\alpha_{ss}^j||\alpha_{ss}^{j-1}|^2$$

$$+ie^{-i\varphi}\frac{T_{j-1}}{2}|\alpha_{ss}^{j-1}||\alpha_{ss}^j|^2 + ie^{i\varphi}\frac{T'_j}{2}|\alpha_{ss}^{j+1}||\alpha_{ss}^j|^2 - \Omega_p^j = 0, \qquad (71)$$

where one sets $\Delta_j = \Delta_C$, but let us leave it general for any $\Delta_j$. Since the values of the homogeneous quantities at the central region are previously known, it is possible to start from them and iteratively solve for the next site from the center towards the left or right boundary. When iterating to the right boundary, $|\alpha_{ss}^{j+1}|$ is the unknown quantity to

solve given $|\alpha_{ss}^j|$ and $|\alpha_{ss}^{j-1}|$. Similarly, when iterating towards to left boundary, $|\alpha_{ss}^{j-1}|$ is the unknown quantity to solve given $|\alpha_{ss}^j|$ and $|\alpha_{ss}^{j+1}|$. In this way, one can get a good estimation of the whole profile $|\alpha_{ss}^j|$ of the array in a steady state, changing from the target value at the central region towards the boundaries. With this information, one then gets $\Delta_b^j$ via the relation (54), which explicitly reads

$$\Delta_b^j = \Delta_j - 2K_s^j|\alpha_{ss}^j|^2 - K_c^j|\alpha_{ss}^{j+1}|^2 - K_c^{j-1}|\alpha_{ss}^{j-1}|^2 \qquad (72)$$
$$+2|\alpha_{ss}^j|\cos(\varphi)\big[T_{j-1}|\alpha_{ss}^{j-1}| + T_j'|\alpha_{ss}^{j+1}|\big].$$

(ii) Alternatively, one can approximate $|\alpha_{ss}^{j\pm1}| \approx |\alpha_{ss}^j|$ in Eq.(71) and obtain $N$ independent equations to solve for $|\alpha_{ss}^j|$ which have the same form as in Eq.(64), but with inhomogeneous $|\alpha_{ss}^j|$. It reads,

$$|K_s^j + Z_j - Y_j|^2|\alpha_{ss}^j|^6 + 2\big\{[\kappa/2 - \Im(X_j)]\Im(Y_j) \qquad (73)$$
$$-[\Delta_j - \Re(X_j)][K_s^j + Z_j - \Re(Y_j)]\big\}|\alpha_{ss}^j|^4$$
$$+\big\{[\kappa_j/2 - \Im(X_j)]^2 + [\Delta_j - \Re(X_j)]^2\big\}|\alpha_{ss}^j|^2 - (\Omega_p^j)^2 = 0,$$

where one typically sets $\Delta_j = \Delta_C$, but let us leave the expressions general as for method (i). Solving the above equations (73) for the different values of the inhomogenous quantity $Q_j$, one can get a rough estimate for the change of $|\alpha_{ss}^j|^2$ on the left and right boundary regions and the from there estimate $\Delta_b^j$ via Eq.(63).

7. After steps 1-6, one obtains a complete set of inhomogeneous parameters for the amplifier array. With these parameters it is possible to numerically evolve the non-linear equations (50), starting from the initial condition $\alpha_j(t=0) = 0$, and get the exact inhomogeneous steady state solution $\alpha_{ss}^j = \alpha_j(t \to \infty) = |\alpha_{ss}^j|e^{-i\theta_{ss}^j}$. To check if this inhomogeneous result is close to the expected quasi-homogeneous profile of amplitudes $|\alpha_{ss}^j| \approx |\alpha_{ss}^C|$ and phase differences $\varphi_j = \theta_{ss}^{j+1} - \theta_{ss}^j \approx \varphi$ at the central region, one evaluates the differences,

$$W_j = ||\alpha_{ss}^j| - |\alpha_{ss}^C|e^{-i\varphi j}|^2. \qquad (74)$$

If $W_j \ll 1$ for all sites within the central region, i.e. $N_L < j \le N - N_R$, then the inhomogeneous configuration is successful. Notice that this result depends strongly on the size of the left and right buffer regions, but typically taking just a few sites on order $N_L \sim 2$ and $N_R \sim 3$ one can obtain good stable results. Fig.5 shows an example of a quasi-homogeneous configuration for an inhomogeneous profile of the pump amplitudes $\Omega_p^j$ and pump frequencies $\omega_p^j$, for an array of $N = 10$ sites, decomposed as $N_L = 2$, $N_C = 10$, and $N_R = 3$. Other parameters are $J_C = 0.5\kappa_C$, $g_c^C = g_s^C = 0.25\kappa_C$, $\varphi = \pi/2$, and $\Delta_C = 0$. For the same parameters, except for $N_C = 6$, Fig. 6 shows an inhomogeneous configuration in the case of an inhomogeneous configuration of circuit parameters. In particular, the local decay $\kappa_j$ and the bare oscillator frequencies $\omega_b^j$ are inhomogeneously changed with the indicated profiles. Both in Fig. 5 and 6 the resulting steady

state displacement $|\alpha_{ss}^j|^2$ and phase differences $\varphi_j = \theta_{ss}^{j+1} - \theta_{ss}^j$ are quasi-homogeneous in the central region.

8. With the knowledge of the exact inhomogenenous steady state dispolacements $\alpha_{ss}^j = |\alpha_{ss}^j| e^{-i\theta_{ss}^j}$ from step 7, one can use Eqs. (53)-(57) to obtain the inhomogeneous profiles of all effective quantities of the parametric amplifier array, namely $\Delta_j$, $J_j$, $\kappa_j$, $g_c^j$, $g_s^j$ and $\varphi_j$. These effective quantities completely determine the amplifier's dynamics whose performance can be quantified by standard figures of merit such as gain, reverse gain, bandwidth, and noise.

These figures of merit can be measrued directly in an actual circuit designed as in Figs.1 and 2 with the inhomogenous profile obtained from steps 1-8. It is also possible to predict the performance of the directional amplifier array by solving the dynamics of the quantum fluctuations given in Eqs. (51). Solving these linearized equations is done below via standard Quantum Optics methods. The expressions to evaluate the gain, reverse gain, and added noise are given in Eqs. (92)-(98). Using these formulas, Figures 7 (a)-(c) show the predicted performance of the directional amplifier array in the case of ingeneering inhomogeneous pump controls $\Omega_p^j$ and $\omega_p^j$ of Fig.5. Alternatively, Fig. 8(a)-(c), show the performance in the case of inhomogeneous circuit parameters $\kappa_j$ and $\omega_b^j$, of Fig.6. The performance can be excellent using state-of-the-art superconducting circuit technology, obtaining a gain above 20dB, reverse gain below -30dB, and a bandwidth - $\kappa$ and added noise of less than 2 photons.

Notice that it is important to check that the parameters chosen lead to small quantum fluctuations compared to the mean displacements, which is a prerequite of the linearized theory in Eqs.(49)-(57). In particular, one evaluates the normalized occupation of quantum fluctuations $\langle\delta a_j^\dagger \delta a_j\rangle/|\alpha_j^{ss}|^2$ and normalized flux fluctuation $\langle\phi_j^2\rangle/\Phi_0^2$, obtained from Eqs (102), (104), and (106), respectively. Figures 7(d)-(e) and 8 (d)-(e) show that these three quantities are small in our examples of inhomogeneous controls and circuit parameters, respectively.

9. Optionally, if the final inhomogenous configuration is not smooth enough causing unwanted gain ripples or added noise, it is always possible to optimize further.

The simplest way is to go back to step 6 and use the outcome of this step as an initial guess to find an optimized bare detuning profile $\Delta_b^j$. To find this optimal profile, one evaluates and minimizes the following cost function,

$$cost(\Delta_b^j) = \sum_{j=N_C+1}^{N-N_R} W_j, \qquad (75)$$

where the differences in amplitude and phase defined in Eq. (74) are calculated numerically by evolving Eqs. (50) as in step 7. Notice that these differences are only evaluated at the central region $N_L < j \le N - N_R$, where one wants to create a quasi-homogenous profile. Importantly, this optimization only has $N_L + N_R$ unknowns, i.e. local detunings at the left and right buffer regions $\Delta_b^1, ..., \Delta_b^{N_L}$, and $\Delta_b^{N-N_R+1}, ..., \Delta_b^N$, respectively. At the central region the detunings are known from the ideal homogeneous solution of step 4, where one typically takes $\Delta_j = \Delta_C$ over the whole array. This makes the optimization problem not costly due to the typically low number of boundary sites $N_L \sim 2$ and $N_R \sim 3$. If the previous optimization is still not smooth enough, it is possible to do a bigger numerical optimization of the cost function (75), but taking both the detuning profile $\Delta_b^j$ and the inhomogeneous variable $Q_j$ selected in step 5 as unknowns profiles to optimize freely, i.e. $cost = cost(\Delta_b^j, Q_j)$. Notice that $Q_j$ can be either $\Omega_j$, $\kappa_j$ or $K_c^j$, $K_s^j$. Since all system parameters are constant in the central region, this amounts to $2(N_L + N_R)$ unknowns, starting the outcome of step 6 as an initial guess.

All the explicit results shown above are obtained using the profile function $I(l)$ given in Eq.(70). This profile function has the advantange that the buffer regions are typically small on order of just few sites $N_L \sim 2$ and $N_R \sim 3$, but it may happen that the obtained displacement profile is not that smooth due to the non-analyticity of the function at the interface between central and buffer regions. One way to reduce these effects is to replace the profile function $I(l)$ to another with larger buffer regions $N_L$, $N_R \gg 1$ and small central region of just few sites $N_C \sim 1$, or even no sites. In this case, a quasi-

homogeneous profile $\left|\alpha_{ss}^j\right|^2$ is built over the bulk of the array even though part of the sites are considered part of the buffer regions. An example of profile function that behaves in this way reads,

$$
f(j) = \begin{cases} \tanh\left(\frac{j}{\xi_L}\right), & \text{if } 1 \le j \le N_L \\ \tanh\left(\frac{N_L}{\xi_L}\right) = \tanh\left(\frac{N_R}{\xi_R}\right) \approx 1, & \text{if } N_L < j < N_L + N_c \\ \tanh\left(\frac{N+1-j}{\xi_R}\right), & \text{if } N - N_R + 1 \le j \le N \end{cases} .
$$

Where $\xi_L > 1$ and $\xi_R > 1$ control the sweepness of the buffer regioins. Notice it is very important to have large boundaries $N_L$, $N_R \gg 1$, so that in the central region the profile function tends to 1. In addition, the continuity of the function requires, $N_L/N_R = \xi_L/\xi_R$.

## Amplifier performance from quantum theory

In the following, all formulas used in Figs. 7 and 8 for characterizing the amplifier's properties such as gain, reverse gain, bandwidth, added noise, saturation effects, and flux fluctuations are derived.

First, to solve the linear quantum Langevin equations (51), one can write them in matrix form as

$$
\delta\dot{\vec{a}}(t) = -iH_{\mathrm{nh}}\delta\vec{a}(t) + \vec{\xi}_{\mathrm{in}}(t), \tag{76}
$$

where $\delta\vec{a}(t) = [\delta a_j(t), \delta a_j^\dagger(t)]^T$ is the vector of quantum fluctuations, and

$$
\vec{\xi}_{\mathrm{in}}(t) = [\sqrt{\kappa_p^j}f_j^{\mathrm{in}}(t) + \sum_m \sqrt{\kappa_s^m}\delta_{jm}d_{\mathrm{in}}^j(t), \sqrt{\kappa_p^j}f_j^{\mathrm{in}\dagger}(t) + \sum_m \sqrt{\kappa_s^m}\delta_{jm}d_{\mathrm{in}}^{j\dagger}(t)]^T
$$

the vector of input operators describing the signal and/or noise fields entering the amplifier at any of its sites $j$. The non-Hermitian matrix $H_{\mathrm{nh}}$ describes coherent and dissipative processes in a unified way. It is of size $2N \times 2N$ and reads,

$$
H_{\mathrm{nh}} = \begin{pmatrix} M_{jl} - i\frac{\kappa_j}{2}\delta_{jl} & -K_{jl} \\ K_{jl}^* & -M_{jl}^* - i\frac{\kappa_j}{2}\delta_{jl} \end{pmatrix}, \tag{77}
$$

where $M_{jl} = -\Delta_j\delta_{jl} + J_j(e^{-i\varphi_j}\delta_{j+1,l} + e^{i\varphi_j}\delta_{j-1,l})$ are the photon-conserving interactions and

$$
K_{jl} = g_s^j\delta_{jl} + g_c^j(\delta_{j+1,l} + \delta_{j-1,l})
$$

the non-local two-photon parametric pumping processes. The linear equations (76) can be solved in Fourier space as

$$
\delta\vec{a}(\omega) = iG(\omega)\vec{\xi}_{\mathrm{in}}(\omega). \tag{78}
$$

Here, $G(\omega) = (\omega - H_{\mathrm{nh}})^{-1}$ is the Green's function matrix, whereas $\delta\vec{a}(\omega) = [\delta a_j(\omega), \delta a_j^\dagger(-\omega)]^T$, and

$$
\vec{\xi}_{\mathrm{in}}(\omega) = [\sqrt{\kappa_p^j}f_j^{\mathrm{in}}(\omega) + \sum_m \sqrt{\kappa_s^m}\delta_{jm}d_{\mathrm{in}}^j(\omega), \sqrt{\kappa_p^j}f_j^{\mathrm{in}\dagger}(-\omega) + \sum_m \sqrt{\kappa_s^m}\delta_{jm}d_{\mathrm{in}}^{j\dagger}(-\omega)]^T
$$

are the Fourier transforms of the oscillator amplitudes and the noise, respetively. Throughout this document, the frequency dependence $\omega$ indicate its Fourier transform, i.e. $f(\omega) = (\sqrt{2\pi})^{-1/2}\int dt\, e^{i\omega t}f(t)$. Note here that $\omega$ is referred

with respect to $\omega_p^j$ as it is defined in the rotating frame.

Writing Eq.(78) explicitly, the Fourier transform of the fluctuation operators $\delta a_j(\omega)$ reads,

$$\delta a_j(\omega) = i \sum_l G_{jl}(\omega)\xi_{in}^l(\omega) + i \sum_l G_{j,N+l}(\omega)[\xi_{in}^l(-\omega)]^\dagger, \qquad (79)$$

with the noise operators,

$$\xi_{in}^j(\omega) = \sqrt{\kappa_p^j}f_{in}^j(\omega) + \sum_{m=I,O} \sqrt{\kappa_s^m}\delta_{jm}d_{in}^j(\omega), \qquad (80)$$

which satisfy

$$[\xi_{in}^j(\omega), \xi_{in}^{j'\dagger}(\omega')] = \kappa_j\delta_{jj'}\delta(\omega - \omega'), \qquad (81)$$

$$[f_{in}^j(\omega), f_{in}^{j'\dagger}(\omega')] = \delta_{jj'}\delta(\omega - \omega'), \qquad (82)$$

$$[d_{in}^m(\omega), d_{in}^{m'\dagger}(\omega')] = \delta_{mm'}\delta(\omega - \omega'). \qquad (83)$$

Using the above expressions and the input-output relations, one can express the output fields at the signal channels in terms of all input fields of the system, which in Fourier space reads

$$d_{out}^m(\omega) = d_{in}^m(\omega) - \sqrt{2\pi\kappa_s^m}|\alpha_{ss}^m|\delta(\omega) - \sqrt{\kappa_s^m}\delta a_m(\omega) \qquad (84)$$

$$= \sum_{m'} \left[\delta_{mm'} - i\sqrt{\kappa_s^m \kappa_s^{m'}}G_{mm'}(\omega)\right]d_{in}^{m'}(\omega)$$

$$-i \sum_{m'} \sqrt{\kappa_s^m \kappa_s^{m'}}G_{m,N+m'}(\omega)[d_{in}^{m'}(-\omega)]^\dagger$$

$$-i \sum_j \sqrt{\kappa_s^m \kappa_p^j}G_{mj}(\omega)f_{in}^j(\omega)$$

$$-i \sum_j \sqrt{\kappa_s^m \kappa_p^j}G_{m,N+j}(\omega)[f_{in}^j(-\omega)]^\dagger$$

$$-\sqrt{2\pi\kappa_s^m}|\alpha_{ss}^m|\delta(\omega). \qquad (85)$$

To account for the coherent input in the signal channel $m = I$, one considers the following explicit form for the input operators,

$$d_{in}^m(\omega) = \sqrt{2\pi}\alpha_s\delta_{mI}e^{i\theta_{ss}^I}\delta(\omega - \omega_s) + \delta d_{in}^m(\omega), \qquad (86)$$

with $\delta d_{in}(\omega)$ vacuum operators satisfying $[\delta d_{in}^m(\omega), \delta d_{in}^{m'\dagger}(\omega')] = \delta_{mm'}\delta(\omega - \omega')$ and the amplitude of the coherent input signal reads,

$$\alpha_s = \frac{\Omega_s}{\sqrt{\kappa_s^I}}e^{-i\theta_s}. \qquad (87)$$

Notice that all the above expressions are written in a rotating frame with respect to the pump frequency $\omega_p^j$, and therefore, the signal frequency $\omega_s$ is the frequency of the signal with respect to the pump, i.e. $\omega_s = \overline{\omega}_s - \omega_p$, where $\overline{\omega}_s$ is the absolute frequency of the signal in the laboratory frame.

With the above expressions, one can calculate all amplifier properties. Particularly important is the amplitude of the field at the output which reads,

$$\langle d_{out}^m(\omega) \rangle = (\delta_{mI} - i\sqrt{\kappa_s^m \kappa_s^I} G_{mI}(\omega))\langle d_{in}^I(\omega) \rangle$$

$$-i\sqrt{\kappa_s^m \kappa_s^I} G_{m,N+I}(\omega)\langle d_{in}^I(-\omega) \rangle^* - \sqrt{2\pi\kappa_s^m}|\alpha_{ss}^m|\delta(\omega) \quad (88)$$

$$= (\delta_{mI} - i\sqrt{\kappa_s^m \kappa_s^I} G_{mI}(\omega))\sqrt{2\pi}\alpha_s e^{i\theta_{ss}^I}\delta(\omega - \omega_s)$$

$$-i\sqrt{\kappa_s^m \kappa_s^I} G_{m,N+I}(\omega)\sqrt{2\pi}\alpha_s^* e^{-i\theta_{ss}^I}\delta(\omega + \omega_s)$$

$$-\sqrt{2\pi\kappa_s^m}|\alpha_{ss}^m|\delta(\omega). \quad (89)$$

Equation (89) can be used to determine the fluctuation operator at the output, which reads

$$\delta d_{out}^m(\omega) = d_{out}^m(\omega) - \langle d_{out}^m(\omega) \rangle \quad (90)$$

$$= \sum_{m'} \left[\delta_{mm'} - i\sqrt{\kappa_s^m \kappa_s^{m'}} G_{mm'}(\omega)\right]\delta d_{in}^{m'}(\omega)$$

$$-i\sum_{m'} \sqrt{\kappa_s^m \kappa_s^{m'}} G_{m,N+m'}(\omega)[\delta d_{in}^{m'}(-\omega)]^\dagger$$

$$-i\sum_j \sqrt{\kappa_s^m \kappa_p^j} G_{mj}(\omega)f_{in}^j(\omega) - i\sum_j \sqrt{\kappa_s^m \kappa_p^j} G_{m,N+j}(\omega)[f_{in}^j(-\omega)]^\dagger. \quad (91)$$

Using Eqs. (89)-(91) one can evaluate the gain and noise of the amplifier using their standard definitions. In particular, the gain of the amplifier for a signal of frequency $\omega_s$ is given by

$$G(\omega_s) = \kappa_s^I \kappa_s^O |G_{O,I}(\omega_s)|^2, \quad (92)$$

whereas the reverse gain of a signal propagating in the opposite direction reads.

$$G^{(R)}(\omega_s) = \kappa_s^I \kappa_s^O |G_{I,O}(\omega_s)|^2. \quad (93)$$

In addition, the flux noise reads,

$$N_{out}^m = \langle \delta d_{out}^m(t)\delta d_{out}^m(t) \rangle \quad (94)$$

$$= \frac{1}{2\pi}\iint d\omega d\omega' e^{i(\omega-\omega')t}\langle \delta d_{out}^m{}^\dagger(\omega)\delta d_{out}^m(\omega') \rangle \quad (95)$$

$$= \frac{1}{2\pi}\int d\omega\, n_{out}^m(\omega), \quad (96)$$

where $n_{out}^m(\omega)$ is the output noise flux per unit frequency, at the output channels $m = O, I$,

$$n_{out}^m(\omega) = \kappa_s^m \sum_{j=1}^N \kappa_j |G_{m,N+j}(\omega)|^2. \quad (97)$$

With this, the added flux noise per unit frequency at the output ports m = 0 is given by

$$n_{add}(\omega) = \frac{n_{out}^O(\omega)}{G(\omega)}. \tag{98}$$

When the array operates in a directional amplifier steady state, the Green's function matrix elements are characterized by an approximately exponential dependence in position, namely

$$G_{jl}(\omega) \approx G_{j,N+l}(\omega) \approx e^{(j-l)\zeta(\omega)} G_{11}(\omega), \qquad j > l, \tag{99}$$

where $\zeta(\omega)$ is the inverse localization length. In the ideal limit of $\zeta \to \infty$, and near the pump frequency $\omega \sim \omega_p$, the added noise reaches its minimum, given by

$$n_{add}(\omega) \approx 1 + \frac{\kappa_p^I}{\kappa_s^I}. \tag{100}$$

Therefore, the quantum limit $n_{add}(\omega) \to 1$ is approached when $\quad \kappa_p^{I,O} \ll \kappa_s^{I,O}$.

Examples of gain, reverse gain, and added noise are shown in Figs.7(a)-(c) and Fig.8(a)-(c), when stabilizing the amplifier array via inhomogeneous controls and inhomogenous circuit parameters, respectively.

To estimate the effect of saturation in the amplifier array and check the validity of the linearize model for four-wave-mixing, one can compute the photon number occupation at any site as

$$\langle \delta a_j^\dagger(t) \delta a_j(t) \rangle = \frac{1}{2\pi} \iint d\omega d\omega' e^{i(\omega-\omega')t} \langle \delta a_j^\dagger(\omega) a_j(\omega') \rangle$$

$$= \frac{1}{2\pi} \int d\omega \sum_l \kappa_l |G_{j,N+l}(\omega)|^2 \tag{101}$$

$$+ \kappa_s^I |\alpha_s|^2 (|G_{jl}(\omega_s)|^2 + |G_{j,N+l}(-\omega_s)|^2)$$

$$+ \kappa_s^I (\alpha_s^*)^2 e^{-2i\theta_{ss}^I} G_{jl}^*(\omega_s) G_{j,N+l}(-\omega_s) e^{2i\omega_s t}$$

$$+ \kappa_s^I \alpha_s^2 e^{2i\theta_{ss}^I} G_{jl}(\omega_s) G_{j,N+l}^*(-\omega_s) e^{-2i\omega_s t}.$$

Here, the first term comes from the noise photons generated by the amplifier, and the other four terms are due to the coherent signal pump. The total occupation at site *j* then reads,

$$\langle a_j^\dagger(t) a_j(t) \rangle = |\alpha_{ss}^j|^2 + 2|\alpha_{ss}^j| \text{Re}\langle \delta a_j(t) \rangle + \langle \delta a_j^\dagger(t) \delta a_j(t) \rangle, \tag{102}$$

where

$$\langle \delta a_j(t) \rangle = \frac{1}{\sqrt{2\pi}} \int d\omega e^{-i\omega t} \langle \delta a_j(\omega) \rangle, \tag{103}$$

$$= i\sqrt{\kappa_s^I} \alpha_s e^{i\theta_{ss}^I} G_{jl}(\omega_s) e^{-i\omega_s t}$$

$$+ i\sqrt{\kappa_s^I} \alpha_s^* e^{-i\theta_{ss}^I} G_{j,N+l}(-\omega_s) e^{i\omega_s t}. \tag{104}$$

Additionally, the linearized theory allows one to evaluate any circuit quantity such as expectation values or correlations of flux $\phi_j(t)$ or charge $q_j(t)$ operators. In particular, one obtains

$$\frac{\langle \phi_j \rangle}{\Phi_0} = 2 \left( \frac{\phi_{zpf}}{\Phi_0} \right) \text{Re}(\langle a_j(t) \rangle), \tag{105}$$

$$\frac{\langle \phi_j^2 \rangle}{\Phi_0^2} = 2 \left( \frac{\phi_{zpf}}{\Phi_0} \right)^2 (\langle a_j^\dagger(t) a_j(t) \rangle + Re\langle a_j^2(t) \rangle + 1/2), \qquad (106)$$

where the zero-point-flux obtained from the quantization procedure reads $\phi_{zpf} = \sqrt{\hbar Z/2}$. For the validity of the linearization of the dynamics, the parameters of the amplifier should be such that $\frac{\langle \phi_j^2 \rangle}{\Phi_0^2} \ll 1, \ \langle \delta a_j^\dagger(t) \delta a_j(t) \rangle \ll |\alpha_{ss}^j|^2$. Fig.7(d)-(e) and Fig.8(d)-(e) show that this is indeed the case for the examples of parameters and inhomogeneous profiles considered in Figs. 5 and 6, respectively. Notice that calculating (105)-(106) also requires the total displacement of each mode $\langle a_j(t) \rangle$ which is can be determined as

$$\langle a_j(t) \rangle = e^{-i\theta_{ss}^j}(|\alpha_{ss}^j| + \langle \delta a_j(t) \rangle). \qquad (107)$$

In addition to having a stable inhomogeneous configuration $|\alpha_{ss}^j|^2$, the stability of the quantum fluctuations $\delta a_j$ (*t*) around the steady-state configuration $|\alpha_{ss}^j|^2$ is a fundamental requirement for the realization of the directional amplifier array. This is guaranteed by checking that all eigenvalues of $H_{nh}$ in Eq. (77) have negative imaginary parts, which implies that there is no mode in the system whose population grows indefinitely. Therefore, there will be a steady state with a finite photon number. This is done for both examples in Figs. 5-8, where the quantum fluctuations are indeed stable for the chosen parameters.

**Optional auxiliary waveguide for more scalable design**

In the following, some optional improvements to the directional amplifier array of the invention will be discussed. First, one can consider to add an auxiliary waveguide to the amplifier array for distribuiting one pump signal on over all sites without requiring N independent pump sources.

Conceptually, the simplest way to send a pump with proper phases and frequencies on all sites of the array is using *N* independent transmission lines (one per site) as shown in Fig.1. This is reasonable in a state-of-art superconducting circuit implementation provided $N \lesssim 15$. When scaling to larger *N*, one may require more scalable methods as having too many independent signal generations can render the device very bulky. To overcome this problem, one can add an auxiliary array of linear superconducting resonators to distribute a single strong pump into *N* independent sites as shown in Fig.9.

In the following, it is shown how to choose the system parameters in order to induce an effective pump $\Omega_p^j$ with the proper spatial dependence in amplitude and phase required to stabilize a steady-state directional amplifier array as shown in Figs. 5 and 6.

In this alternative design of the device, the Lagrangian $L_p$ in Eq.(2) describing one independent voltage source at each of the *N* ports is replaced by a new waveguide Lagrangian $L_w$ describing the linear resonator array, its coupling to the JJ array, and the voltage sources. This reads,

$$L_w = \sum_{j=1}^N \frac{c_w^j}{2}(\dot{\psi}_j)^2 - \sum_{j=1}^N \frac{(\psi_j)^2}{2L_w^j} + \sum_{j=1}^{N-1} \frac{\bar{c}_w^j}{2}(\dot{\psi}_{j+1} - \dot{\psi}_j)^2$$

$$+ \sum_{j=1}^N \frac{c_p^j}{2}(\dot{\psi}_j - \dot{\phi}_j)^2 + \sum_{j=1,N} \frac{c_{wp}^j}{2}(\dot{\psi}_j - V_p^j(t))^2. \qquad (108)$$

As shown in Fig. 9, here $\psi_j(t)$ are the flux operators at site *j* of the auxiliary array, $L_w^j$ and $C_w^j$ the local inductance and capacitance of the resonator at site *j*, $\bar{C}_w^j$ the capacitance couplings between neighboring states within the waveguide, $C_p^j$ the inter-array capacitance couplings between sites $j$ of each array, and $C_{wp}^j$ are the coupling capacitances at both extremes of the waveguide $j = 1$ and $j = N$, where one connects a transmission line with voltage $V_p^j(t)$. Notice that in this design, one only requires two transmission lines at sites $j = 1$ and $j = N$. Moreover, one only requires one pump source at site $j = 1$ and the last site $j = N$ will be only used to induce local dissipation to engineer the proper boundary conditions of the pump field $\Omega_p^j$, as shown below. The total Lagrangian of the device then reads $L' = L_{JJ} + L_s + L_w$, where $L_{JJ}$ and $L_s$ describe the JJ array and the signal voltages as given in Eqs.(1) and (3), respectively.

In addition, it would be desired to to induce local losses $\kappa_j$ on all sites, without requiring one transmission line per site as in Fig.1. To do so, one can use on-chip microwave attenuators, which can be modeled as resistive elements $R_j$ that effectively cause local dissipation of microwave photons at site $j$ of the JJ array (see Fig.9). In this way, one only uses transmission lines at the input and output sites $m = I, O$, to send and retrieve the quantum signals, but at all other sites, local dissipation is induced by these local resistors. Importantly, this alternative design requires a total of 4 transmission lines independent of the number of sites $N$, improving scalability. In particular, there are 2 transmission lines on the JJ array for sending and retrieving the signals, and 2 in the auxiliary waveguide in order to send the pump on one border and perfectly absorb it on the other. The total decay rate at site $j$ reads $\kappa_j = \kappa_R^j + \kappa_s^j$, where $\kappa_R^j$ is induced by the on-chip resistors and $\kappa_s^j$ by the actual transmission line waveguide for the signals.

The effective local decay $\kappa_R^j$ induced by the local resistor $R_j$,

$$\kappa_R^j = \frac{1}{C_{eq}^j R_j},$$

(109)

for $j \neq I, O$, whereas for $j = I, O$, the decay rate is the standard from the input/output transmission lines to send/retrieve the signals and it is given in Eq.(40). A directional amplifier array with large bandwidth demands a nearly homogeneous local decay of order $\kappa_j/(2\pi)$ - $[0.2, 1]$ GHz. Therefore, for the sites with resistors $\kappa_j = \kappa_R^j$ ($j \neq I, O$), the corresponding resistance should be on order $R_j \sim [160, 800]\Omega$ for $C_{eq}^j \sim 1\text{pF}$. Due to the topological origin of the directional steady state, the device is resilient up to $\sim 10\%$ of spatial variation in local dissipation rates $\kappa_R^j$ which implies a similar tolerance to variation in these resistances $R_j$ in the $\sim 10\%$ range. For the sites with input/output transmission lines ($j = I, O$), one requires $\kappa_p^{I,O} \ll \kappa_s^{I,O}$, and to maintain the homogeneity in the total decay rate one also needs $\kappa_s^{I,O} = \kappa_{I,O} - \kappa_p^{I,O} \lesssim \kappa_{j \neq I,O}$.

These conditions can also be set within 10% error using current superconducting technology.

Following the same procedure as for the JJ array, one can obtain the total Hamiltonian of the modified design with auxiliary waveguide from the Legendre transformation, $H' = \sum_j (\dot{\phi}_j q_j + \dot{\psi}_j q_w^j) - L'$. Notice that now flux and

$$q_w^j = \frac{\partial L_w'}{\partial \dot{\psi}_j}$$

charge are dynamical variables $\psi_j$ and for the waveguide in addition $\phi_j$ and $q_j$ for the JJ array. It is convenient to decompose the resulting Hamiltonian as $H' = H_{JJ} + H_w + H_{TR}'$, where $H_{JJ}$ is as given in Eq.(6), $H_w$ describes the waveguide and its coupling to the JJ array, and $H_{TR}'$ describes the coupling to the 4 transmission lines and the voltage sources. Explicitly,

$$H_{\mathrm{w}} = \sum_{j=1}^{N} \frac{1}{2C_{eq,w}^{j}} (q_{\mathrm{w}}^{j})^2 + \sum_{j=1}^{N} \frac{1}{2L_{\mathrm{w}}^{j}} \psi_{j}^{2} \tag{110}$$

$$+ \sum_{j=1}^{N-1} \frac{\bar{c}_{\mathrm{w}}^{j}}{C_{eq,w}^{j} C_{eq,w}^{j+1}} q_{\mathrm{w}}^{j} q_{\mathrm{w}}^{j+1} + \sum_{j=1}^{N} \frac{c_{p}^{j}}{C_{eq}^{j} C_{eq,w}^{j}} q^{j} q_{\mathrm{w}}^{j},$$

$$H_{\mathrm{T}R}' = \sum_{j=1,N} \frac{c_{wp}^{j}}{C_{eq,w}^{j}} q_{\mathrm{w}}^{j} V_{p}^{j}(t) + \sum_{m=I,O} \frac{c_{s}^{m}}{C_{eq}^{m}} q_{m} V_{s}^{m}(t). \tag{111}$$

Here, the charge variable $q_{\mathrm{w}}^{j}$ at site $j$ of the auxiliary waveguide reads,

$$q_{\mathrm{w}}^{j} = \frac{\partial L'}{\partial \dot{\psi}_{j}} = C_{eq,w}^{j} \dot{\psi}_{j} - \bar{C}_{\mathrm{w}}^{j-1} \dot{\psi}_{j-1} - \bar{C}_{\mathrm{w}}^{j} \dot{\psi}_{j+1}$$

$$- \delta_{j1} C_{wp}^{1} V_{p}^{1}(t) - \delta_{jN} C_{wp}^{N} V_{p}^{N}(t) - C_{p}^{j} \dot{\phi}_{j}, \tag{112}$$

with the total equivalent capacitance $C_{eq,w}^{j}$ at site $j$ of the auxiliary waveguide given by,

$$C_{eq,w}^{j} = C_{j} + \bar{C}_{j-1} + \bar{C}_{j} + C_{p}^{j} + \delta_{j1} C_{wp}^{1} + \delta_{jN} C_{wp}^{N}. \tag{113}$$

Applying the standard quantization procedure to the modified total Hamiltonian $H'$, one can promote the charge and flux variables of the waveguide in terms of annihilation and creation operators. This has been already done for the JJ array in Eqs.(11)-(12), and here this is applied to describe the waveguide, namely

$$\psi_{j} = \sqrt{\frac{\hbar Z_{\mathrm{w}}^{j}}{2}} (b_{j}^{\dagger} + b_{j}), \tag{114}$$

$$q_{\mathrm{w}}^{j} = i \sqrt{\frac{\hbar}{2Z_{\mathrm{w}}^{j}}} (b_{j}^{\dagger} - b_{j}). \tag{115}$$

Here, $b_{j}$ and $b_{j}^{\dagger}$ destroy and annihilate an excitation at site $j$ of the waveguide, and they satisfy canonical commutation relations, $[b_{j}, b_{l}^{\dagger}] = \delta_{jl}$ such that $[\psi_{j}, q_{\mathrm{w}}^{l}] = i\hbar\delta_{jl}$. In addition, the effective impedance at site $j$ reads $Z_{\mathrm{w}}^{j} = \sqrt{L_{\mathrm{w}}^{j}/C_{eq,w}^{j}}$. In terms of the waveguide Fock operators $b_{j}$ as well as the JJ array operators $a_{j}$ introduced before, the Hamiltonian $H_{w}$ in Eq.(110) takes the form,

$$\frac{H_{\mathrm{w}}}{\hbar} = \sum_{j=1}^{N} \omega_{\mathrm{w}b}^{j} b_{j}^{\dagger} b_{j} + \sum_{j=1}^{N-1} J_{\mathrm{w}}^{j} (b_{j+1}^{\dagger} b_{j} + b_{j}^{\dagger} b_{j+1})$$

$$+ \sum_{j=1}^{N} \bar{J}_{\mathrm{w}}^{j} (a_{j}^{\dagger} b_{j} + b_{j}^{\dagger} a_{j}), \tag{116}$$

where $\omega_{\mathrm{w}}^{j} = (C_{eq,w}^{j} L_{\mathrm{w}}^{j})^{-1/2}$ is the local frequency of the linear superconducting resonators at site $j$. In addition, the intra- and inter-array coupling rates $J_{\mathrm{w}}^{j}$ and $\bar{J}_{\mathrm{w}}^{j}$ read

$$J_{\mathrm{w}}^{j} = \frac{\bar{c}_{\mathrm{w}}^{j}(z_{\mathrm{w}}^{j}z_{\mathrm{w}}^{j+1})^{-1/2}}{2c_{eq,w}^{j}c_{eq,w}^{j+1}} = \frac{(\omega_{\mathrm{w}}^{j}\omega_{\mathrm{w}}^{j+1})^{1/2}\bar{c}_{\mathrm{w}}^{j}}{2(c_{eq,w}^{j}c_{eq,w}^{j+1})^{1/2}}, \tag{117}$$

$$\bar{J}_{\mathrm{w}}^{j} = \frac{c_{p}^{j}(Z_{j}Z_{\mathrm{w}}^{j})^{-1/2}}{2c_{eq}^{j}c_{eq,w}^{j}} = \frac{(\widetilde{\omega}_{b}^{j}\omega_{\mathrm{w}}^{j})^{1/2}c_{p}^{j}}{2(c_{eq}^{j}c_{eq,w}^{j})^{1/2}}, \tag{118}$$

Similarly as in Eq.(21), achieving Eq.(116) requires performing the rotating wave approximation (RWA) provided couplings are much weaker than transition frequencies and one has neglected long-range interactions provided the coupling capacitances are much weaker than the total equivalent capacitance per site, i.e. $\bar{c}_{\mathrm{w}}^{j}, c_{p}^{j} \ll c_{eq,w}^{j}, c_{eq}^{j}$ .

In addition, considering sinusoidal external voltages for $V_{p}^{j}(t)$ and $V_{s}^{m}(t)$ as in Eqs.(24)-(25), it is instructive to further decompose the transmission line Hamiltonian as $H_{TR}' = H_{p}, + H_{s} + H_{diss}'$. Here, $H_{p}$, and $H_{s}$ describe the coherent drives due to pump and signal drives at sites $b_{1}$ and $a_{l}$, respectively. Hamiltonian $H_{s}$ is given in Eq. (33) and $H_{p}$, reads

$$\frac{H_{p\prime}}{\hbar} = 2i\Omega_{\mathrm{w}}\cos(\omega_{p}t + \theta_{p})(b_{1}^{\dagger} - b_{1}) \tag{119}$$

$$\approx i\Omega_{\mathrm{w}}(e^{-i(\omega_{p}t+\theta_{p})}b_{1}^{\dagger} - e^{i(\omega_{p}t+\theta_{p})}b_{1}). \tag{120}$$

Note that in Eq. (120) the RWA is performed given $\Omega_{\mathrm{w}}, \Omega_{s} \ll \omega_{\mathrm{w}}^{j}, \omega_{b}^{j}$ . The Hamiltonian describing the dissipation $H_{diss}'$ contains the voltage quantum fluctuations $\delta V_{p}^{j}(t)$ and $\delta V_{s}^{m}(t)$ which can also be expressed as in Eqs.(37)-(38) assuming semi-infinite transmission lines. Applying standard Markovian input-output theory to the interaction Hamiltonian $H_{diss}'$, one obtains modified quantum Langevin equations describing the coherent and dissipative processes that take place in the extended device including JJ and auxiliary waveguide arrays. Explicitly, the coupled equations for $\dot{a}_{j}$ and $\dot{b}_{j}$ read

$$\dot{a}_{j} = \frac{i}{\hbar}[H_{JJ} + H_{\mathrm{w}} + H_{p\prime\prime}, a_{j}] - \frac{\kappa_{j}}{2}a_{j} \tag{121}$$

$$+ \sum_{j'\neq I,O} \delta_{jj'}\sqrt{\kappa_{R}^{j'}}\tilde{r}_{\mathrm{in}}^{j'}(t) + \sum_{m=I,O} \delta_{jm}\sqrt{\kappa_{s}^{m}}\bar{d}_{\mathrm{in}}^{m}(t),$$

$$\dot{b}_{j} = \frac{i}{\hbar}[H_{JJ} + H_{\mathrm{w}} + H_{c\prime\prime}, b_{j}] - \frac{\kappa_{\mathrm{w}}^{j}}{2}b_{j} + \sqrt{\kappa_{\mathrm{w}}^{j}}\tilde{f}_{j}^{\mathrm{in}}(t). \tag{122}$$

Here, the decay rates $\kappa_{\mathrm{w}}^{j}$ due to the coupling to transmission lines at both extremes ($j = 1, N$) of the auxiliary waveguide read

$$\kappa_w^j = \left(\frac{c_{wp}^j}{2c_{eq,w}^j}\right)^2 \left(\frac{z_{TR}}{z_w^j}\right) \omega_w^j (\delta_{j1} + \delta_{jN}). \tag{123}$$

In addition, the decay rates $\kappa_s^j$ due to the transmission lines to send/retrieve the signals are given in Eq.(41) and, finally, the decay rates $\kappa_R^j$ due to the local on-chip dissipators are given in Eq.(109). Note that input operators $\tilde{r}_{in}^j(t)$ are artificially added to describe in the same formalism the local dissipation due to resistors, but they do not correspond to physical input ports to propagate signals. The total decay rate on the JJ array is given by $\kappa_j = \kappa_R^j + \kappa_s^j$. Finally, note that in Eq. (121) a displacement transformation is performed in the noise operator of the signal channel $m = l$ as given in Eqs. (44) and (47).

Now, the four-wave mixing analysis is applied for the case of the device including auxiliary waveguide. Here, one considers a strong pump only in the input port corresponding to site $b_1$ of the waveguide. Due to the coupling between all $b_j$ and $a_j$ sites, this strong pump displaces all these modes as $a_j = (\alpha_j + \delta\tilde{a}_j)e^{-i\omega_p^1 t}$ for the JJ array (as in Eq.(49)) and also $b_j = (\beta_j + \delta\tilde{b}_j)e^{-i\omega_p^1 t}$ for the waveguide array. Here, $\delta a_j$ and $\delta b_j$ are quantum fluctuations around the large mean displacements $\alpha_j$ and $\beta_j$, respectively. Using the previous ansatz in Eqs. (121)-(122), one can find classical coupled equations for the mean displacements, which generalize Eqs.(50) by including the coupling to the resonator waveguide:

$$\dot{\alpha}_j = -(\frac{\kappa_j}{2} - i\Delta_b^j)\alpha_j \tag{124}$$
$$-i(J_b^j + T_j'|\alpha_j|^2 + \frac{T_j}{2}|\alpha_{j+1}|^2)\alpha_{j+1}$$
$$-i(J_b^{j-1} + T_{j-1}|\alpha_j|^2 + \frac{T_{j-1}'}{2}|\alpha_{j-1}|^2)\alpha_{j-1}$$
$$+iK_s^j|\alpha_j|^2\alpha_j + iK_c^j|\alpha_{j+1}|^2\alpha_j + iK_c^{j-1}|\alpha_{j-1}|^2\alpha_j$$
$$+i\frac{K_c^j}{2}\alpha_j^*\alpha_{j+1}^2 + i\frac{K_c^{j-1}}{2}\alpha_j^*\alpha_{j-1}^2$$
$$-i\frac{T_{j-1}}{2}\alpha_{j-1}^*\alpha_j^2 - i\frac{T_j'}{2}\alpha_{j+1}^*\alpha_j^2 - iJ_w^j\beta_j,$$

$$\dot{\beta}_j = -(\frac{\kappa_w^j}{2} - i\Delta_w^j)\beta_j - iJ_w^{j-1}\beta_{j-1} - iJ_w^j\beta_{j+1} \tag{125}$$
$$+\Omega_w\delta_{j1}e^{-i\theta_p} - iJ_w^j\alpha_j.$$

Here, $\Delta_b^j = \omega_p - \omega_b^j$ and $\Delta_w^j = \omega_p - \omega_w^j$ are the detunings between pump frequency and local frequencies of JJ array or waveguide, respectively. Note also that in the pump term $\sim \Omega_W$ the RWA is applied, provided $J_w^j, \bar{J}_w^j \ll \omega_w^j \lesssim \Omega_w$.

One is now in a position to look for the steady-state solution of the system of equations (124)-(125), namely

$$\alpha_{ss}^j = \alpha_j(t \to \infty) \quad \text{and} \quad \beta_{ss}^j = \beta_j(t \to \infty)$$

), which are obtained when $\dot{\alpha}_j = \dot{\beta}_j = 0$. From Eq.(125), one can formally solve for $\beta_{ss}^j$ as

$$\beta_{ss}^j = [I^{-1}]_{j1}\Omega_{\mathrm{w}}e^{-i\theta_p} - i\sum_{l=1}^{N}[I^{-1}]_{jl}\bar{J}_{\mathrm{w}}^l\alpha_{ss}^l, \qquad (126)$$

where the matrix $[I^{-1}]_{jl}$ is the inverse of the matrix $I$, which reads

$$I_{jl} = \left(\frac{\kappa_{\mathrm{w}}^j}{2} - i\Delta_{\mathrm{w}}^j\right)\delta_{jl} + iJ_{\mathrm{w}}^{j-1}\delta_{l,j-1} + iJ_{\mathrm{w}}^j\delta_{l,j+1}. \qquad (127)$$

Importantly, in the case $\Delta_{\mathrm{w}}^j = 0, J_{\mathrm{w}}^j = J_{\mathrm{w}}$, and $\kappa_{\mathrm{w}}^j = 2J_{\mathrm{w}}(\delta_{j1} + \delta_{jN})$, the inverse of matrix $I$ has the exact solution:

$$[I^{-1}]_{jl} = \frac{e^{-i(\pi/2)|j-l|}}{2J_{\mathrm{w}}}. \qquad (128)$$

Replacing (128) into Eq.(126), one sees that under the above special conditions, the steady-state solution for the waveguide displacements correspond to a plane-wave with phase $\varphi = \pi/2$,

$$\beta_{ss}^j = \frac{i\Omega_{\mathrm{w}}}{2J_{\mathrm{w}}}e^{-i(\varphi j + \theta_p)} - i\sum_{l=1}^{N}\frac{\bar{J}_{\mathrm{w}}^l}{2J_{\mathrm{w}}}e^{-i\varphi|j-l|}\alpha_{ss}^l, \qquad (129)$$

up to a correction on order $\sim (\bar{J}_{\mathrm{w}}^l/2J_{\mathrm{w}})\alpha_{ss}^l$, which is small in the strong pump limit, $\Omega_{\mathrm{w}} \gg J_{\mathrm{w}} \sim \bar{J}_{\mathrm{w}}^j$ required for the four-wave mixing process.

This solution exists due to a perfect impedance matching condition for excitations propagating on the auxiliary waveguide implying that excitations propagating to the right with $\varphi = \pi/2$ are perfectly absorbed at the right boundary without any reflections and therefore a plane-wave becomes a steady state solution. As shown above, the existence of this steady state requires that the waveguide intra-array hopping to be homogeneous $J_{\mathrm{w}}^j = J_{\mathrm{w}}$, that all local waveguide frequencies are homogeneous and on-resonance with the pump frequency $\omega_{\mathrm{w}}^j = \omega_p$, and that the two sinks on the boundaries of the waveguide have an equal decay rate $\kappa_{\mathrm{w}}^1 = \kappa_{\mathrm{w}}^N = 2J_{\mathrm{w}}$. Replacing Eq. (129) in (124), one can see that $\beta_{ss}^j$ induces an effective driving on the JJ array with a phase that increases linearly with $\varphi = \pi/2$ and whose strength reads

$$\Omega_p^j = \frac{\bar{J}_{\mathrm{w}}^j}{2J_{\mathrm{w}}}\Omega_{\mathrm{w}}. \qquad (130)$$

In addition, the auxiliary waveguide also induces collective super-radiant decay with rate

$$\gamma_j = \frac{(\bar{J}_{\mathrm{w}}^j)^2}{2J_{\mathrm{w}}}, \qquad (131)$$

mediated by the traveling wave with phase $\varphi = \pi/2$. To see this explicitly, one can write the effective non-linear equation for $\alpha^j_{ss}$, which read

$$-(\frac{\kappa_j}{2} - i\Delta^j_b)\alpha_j - i(J^j_b + T'_j|\alpha_j|^2 + \frac{T_j}{2}|\alpha_{j+1}|^2)\alpha_{j+1} \qquad (132)$$

$$-i(J^{j-1}_b + T_{j-1}|\alpha_j|^2 + \frac{T'_{j-1}}{2}|\alpha_{j-1}|^2)\alpha_{j-1}$$

$$+iK^j_s|\alpha_j|^2\alpha_j + iK^j_c|\alpha_{j+1}|^2\alpha_j + iK^{j-1}_c|\alpha_{j-1}|^2\alpha_j$$

$$+i\frac{K^j_c}{2}\alpha^*_j\alpha^2_{j+1} + i\frac{K^{j-1}_c}{2}\alpha^*_j\alpha^2_{j-1}$$

$$-i\frac{T_{j-1}}{2}\alpha^*_{j-1}\alpha^2_j - i\frac{T'_j}{2}\alpha^*_{j+1}\alpha^2_j + \Omega^j_p e^{-i(\varphi j + \theta_p)}$$

$$-\sum^N_{l=1}\sqrt{\gamma_j\gamma_l}e^{-i\varphi|j-l|}\alpha^l_{ss} = 0.$$

The last line in the above Eq.(132) describes the collective super-radiant decay which can be neglected provided the coupling to the traveling mode at site $j$ is much smaller than all other quantities in the effective dynamics, namely $\gamma_j \ll \Omega^j_p, \kappa_j, |\Delta^j_b|, K^j_s|\alpha^j_{ss}|^2, K^j_c|\alpha^j_{ss}|^2$. In this case, one effectively obtains the same equation for $\alpha_{ss}$ as the case without the waveguide in Eq.(59). Note that the presence of additional local decay on the bulk of the auxiliary waveguide, i.e. $\kappa^j_w \neq 0$ for $1 < j < N$, deteriorates the perfect absorbing conditions, but the topological origin of the amplifying steady state makes it robust to this disorder as long as this unwanted decay is much smaller than $J_w$.

Regarding the dynamics of the quantum fluctuations $\delta a_j$ and $\delta b_j$, one can also linearize the dynamics provided $|\alpha^j_{ss}|^2 \gg \langle\delta a^\dagger_j \delta a_j\rangle$ as done for the design without auxiliary waveguide. Starting from Eqs.(121)-(122) and going to a rotating frame with the pump frequency $\omega^1_p$, the resulting coupled quantum Langevin equations for fluctuations in the JJ array and the waveguide read,

$$\delta\dot{a}_j = i[H_{pa}, \delta a_j] - \frac{\kappa_j}{2}\delta a_j - \sqrt{\kappa^j_R}\delta r^j_{in}(t)$$

$$-\sum_{m=I,O}\sqrt{\kappa^m_s}\delta_{jm}d^m_{in}(t) - i\tilde{J}^j_w\delta b_j, \qquad (133)$$

$$\delta\dot{b}_j = -\sum^N_{l=1}I_{jl}\delta b_l - i\tilde{J}^j_w\delta a_j - \sum_{j'=1,N}\sqrt{\kappa^{j'}_p}\delta_{jj'}f^{j'}_{in}(t), \qquad (134)$$

with $H_{pa}$ the parametric Hamiltonian given in Eq.(52) and $I_{jl}$ the matrix in Eq.(127). Provided $\delta a_j$ and $\delta b_j$ are far-detuned, $\tilde{J}_w \ll |\omega^j_b - \omega_w|$, the above equations decouple up to small corrections $\sim \tilde{J}^2_w/|\omega^j_b - \omega_w|$. Under these conditions, one can thus neglect the last term in Eq.(133) and recover the same Langenvin in Eq.(51) as the case without auxiliary waveguide.

Alternatively, one can also adiabatically eliminate the waveguide fluctuations $\delta b_j$ in the case the perfect impedance matching discussed above are fulfilled, since then the waveguide reaches its steady-state in a short time-scale. To do so, one sets $\delta b_j \approx 0$ in Eq.(134) and using (128) one formally solves for $b_j$, obtaining

$$\delta b_j(t) \approx -i \sum_{l=1}^{N} \frac{\bar{J}_{\mathrm{w}}^{l}}{2J_{\mathrm{w}}} e^{-i\varphi|j-l|} \delta a_l - i \sum_{\mu=\pm 1} \frac{e^{-i\mu\varphi j}}{\sqrt{2J_{\mathrm{w}}}} \bar{f}_{\mathrm{in}}^{\mu}(t), \qquad (135)$$

with the modified input operators for $\mu = \pm 1$, given by,

$$\bar{f}_{\mathrm{in}}^{\mu}(t) = -ie^{i\frac{\mu}{2}\varphi[(1-N)\mu+(1+N)]} f_{\mathrm{in}}^{\frac{1}{2}[(1-N)\mu+(1+N)]}(t). \qquad (136)$$

Replacing this into Eq.(133), one obtains

$$\delta \dot{a}_j = i\left[H_{\mathrm{pa}}, \delta a_j\right] - \frac{\kappa_j}{2}\delta a_j - \sqrt{\kappa_R^j}\delta r_{\mathrm{in}}^j(t) - \sum_{m=I,O} \sqrt{\kappa_s^m}\delta_{jm}d_{\mathrm{in}}^m(t) \qquad (137)$$

$$- \sum_{l=1}^{N} \sqrt{\gamma_j\gamma_l}e^{-i\varphi|j-l|}\delta a_l - \sum_{\mu=\pm 1} \sqrt{\gamma_j}e^{-i\mu\varphi j}\bar{f}_{\mathrm{in}}^{\mu}(t),$$

with $\gamma_j$ the decay rate of the resonator at site $j$ into travelling waves propagating to the right ($\mu = +1$) and to the left ($\mu = -1$) of the waveguide. The last line in Eq.(137) corresponds to the standard terms for collective superradiant decay mediated by a waveguide. Collective decay can be neglected provided $\gamma_j$ is much smaller than all other system quantities as done for the classical displacements in Eq.(132). In this case, Eq.(137) reduces to Eq.(51) as there was no waveguide.

Therefore, under the conditions discussed above, the auxiliary waveguide is merely a way to obtain the desired collective pump without having one transmission line and signal generator per site. The only drawback is that the waveguide also induces collective decay, but this can be made negligible compared to all other timescales.

In the waveguide design of Fig. 9, engineering a profile of inhomogeneous controls requires engineering circuit parameters. First, the phase $\varphi = \pi/2$ is already achieved by having the homogenous conditions $\Delta_{\mathrm{w}}^j = 0, \; J_{\mathrm{w}}^j = J_{\mathrm{w}}$, and $\kappa_{\mathrm{w}}^j = 2J_{\mathrm{w}}(\delta_{j1} + \delta_{jN})$. Then, the inhomogeneity of the effective pump strengths $\Omega_p^j = (\bar{J}_{\mathrm{w}}^j/2J_{\mathrm{w}})\Omega_{\mathrm{w}}$ can be controlled via $\bar{J}_{\mathrm{w}}^j$. Finally, the detunings $\Delta_b^j = \omega_p^1 - \omega_b^j$ can be controlled inhomogeneously via $\omega_b^j$. These, in turn, can be controlled either via the equivalent capacitance $C_{eq}^j$ or inductance $L_{eq}^j$. This can be done with or without changing the Kerr non-linearities depending on what circuit parameter that one varies. In particular, when changing the total inductance by keeping the ratio $\lambda_j = E_J^j/(2\bar{E}_J^j)$ constant, the Kerr non-linearities remain unchanged.

Instead of controlling the circuit parameters to engineer the inhomogeneities, it is possible to envision a hybrid design, which uses a fully homogeneous auxiliary waveguide only in the central region of the device, i.e. $N_L < j \le N - N_R$, see Fig. 4. On the left and right buffer regions, i.e. $j \le N_L$ and $j > N - N_R$, one can use standard independent transmission lines to send the required pump drives $\Omega_p^j$. This hybrid scheme is depicted in Fig.10 and has the great advantage of allowing us to have a fully homogeneous circuit, that is scalable for large $N$ due to the auxiliary waveguide, and yet it is possible to control the inhomogeneous boundaries via few control lines.

**Other optional designs: SQUID non-linear inductances**

As it is well known, replacing each JJ of the device by a SQUID, i.e. two identical JJs on parallel and threatening a flux $\Phi_{\mathrm{ext}}$ around the resulting loop, allows one to build an effective JJ with flux-tunable Josephson energy given by $E_J(\Phi_{\mathrm{ext}}) = E_J(0)\cos(\Phi_{\mathrm{ext}}/(2\Phi_0))$, see Fig.11 (a). Tunable JJs can be applied to any of the previous designs and enable the control of the strength of the local non-linearities, however, it also makes the device more susceptible to external flux noise.

**Other optional designs: Quarton non-linear inductance**

Here, it is analyzed how using a Quarton non-linearity instead of a normal JJ non-linearity. As shown below, in this case the dynamics of the device remains formally the same, but it is possible to reach larger values of $K_c^j$, and thereby increase the bandwidth of the device.

First, regarding on-site non-linear inductances, one shall replace all the on-site JJ non-linearities with Lagrangian

$$L_{JJ,on-site}^j = E_J^j \cos\left(\frac{\phi_j}{\Phi_0}\right), \tag{138}$$

by Quartons on parallel to linear inductor $L_j$ as shown in Fig.11(b). The modified Langragian reads,

$$L_{Q,on-site}^j = n E_J^j \cos\left(\frac{\phi_j}{n\Phi_0}\right) + \alpha_j E_J^j \cos\left(\frac{\phi_j - \Phi_{ext}^j}{\Phi_0}\right) - \frac{1}{2L_j}\phi_j^2, \tag{139}$$

where n is the number of JJs in series that form the Quarton. To have a pure Quarton, one requires an external flux of half flux quantum, $\Phi_{ext}^j = \pi\Phi_0$ and $\alpha_j$ = 1/n. Then the pure Quantum Lagrangian reads,

$$L_{Q,on-site}^j = n E_J^j \cos\left(\frac{\phi_j}{n\Phi_0}\right) - \frac{E_J^j}{n}\cos\left(\frac{\phi_j}{\Phi_0}\right) - \frac{1}{2L_j}\phi_j^2. \tag{140}$$

Expanding this Lagrangian for small flux $\langle\phi_j^2\rangle^{1/2} \ll \Phi_0$, one gets

$$L_{Q,on-site}^j = -\frac{1}{2L_j}\phi_j^2 + \frac{E_Q^j}{24(\Phi_0)^4}\phi_j^4 + O(\phi_j^6), \tag{141}$$

with the on-site Quarton energy given by

$$E_Q^j = -\frac{(n^2-1)}{n^3} E_J^j. \tag{142}$$

Note that the quadratic term is not present for a pure Quarton. This is the key for increasing the bandwidth. It is enough to consider the simplest case of n = 2, obtaining $E_Q^j = -(3/8)E_J^j$.

In addition, for inter-site non-linear inductances, one also replaces all Josephson junctions,

$$L_{JJ,inter-site}^j = \bar{E}_J^j \cos\left(\frac{\phi_{j+1}-\phi_j}{\Phi_0}\right), \tag{143}$$

by standard pure Quartons with n = 2 on parallel with a linear inductance $\bar{L}_j$, namely

$$L_{Q,inter-site}^j = 2\bar{E}_J^j \cos\left(\frac{\phi_{j+1}-\phi_j}{2\Phi_0}\right) - \frac{1}{2}\bar{E}_J^j \cos\left(\frac{\phi_{j+1}-\phi_j}{\Phi_0}\right)$$

$$- \frac{1}{2\bar{L}_j}(\phi_{j+1} - \phi_j)^2. \tag{144}$$

Note that the linear coupling inductance $\bar{L}_j$ can be typically taken out from the design, as well as the coupling capacitance $\bar{C}_j$. However, a small remaining capacitance may be practical to cancel small residual linear inductive couplings (tilted Quarton). Expanding this for low phase-drop, one gets

$$L^j_{Q,inter-site} = -\frac{1}{2\bar{L}_i}(\phi_{j+1} - \phi_j)^2 + \frac{\bar{E}^j_Q}{24(\Phi_0)^4}\phi^4_j + O(\phi^6_j), \qquad (145)$$

$$\bar{E}^j_Q = -(3/8)\bar{E}^j_J$$

with .

Applying these replacements in the total Hamiltonian for the array in Eq.(8), the Hamiltonian of the device with pure Quarton non-linearities retains the same form except for these new identifications:

$$L^j_{eq} \rightarrow L_j, \qquad (146)$$

$$\bar{L}^j_J \rightarrow \bar{L}_j, \qquad (147)$$

$$E^j_J \rightarrow E^j_Q = -(3/8)E^j_J, \qquad (148)$$

$$\bar{E}^j_J \rightarrow \bar{E}^j_Q = -(3/8)\bar{E}^j_J. \qquad (149)$$

Therefore, it is simple to evaluate the consequences of having pure Quarton nonlinearities instead of JJs. The most important implication is that now the cross- and self-Kerr nonlinearities are not bounded by the ratio $\lambda_j = E^j_J/(2\bar{E}^j_J)$ between on-site and inter-site non-linearities. To show this advantage explicitly, let us consider the case of homogeneous circuit parameters, for which the Hamiltonian (21) of the system depends on the following homogeneous quantities,

$$\widetilde{\omega}_b = 1/\sqrt{C_{eq}L_{eq}} = 1/\sqrt{C_{eq}L}, \qquad (150)$$

$$\omega_b = \widetilde{\omega}_b - K_s - K_c, \qquad (151)$$

$$J_b = \frac{\widetilde{\omega}_b}{2}\left(\frac{\bar{C}}{C_{eq}} - \frac{L_{eq}}{\bar{L}}\right) + K_c = \frac{\widetilde{\omega}_b}{2}\left(\frac{\bar{C}}{C_{eq}} - \frac{L}{\bar{L}}\right) + K_c, \qquad (152)$$

$$K_s = K_c(1 + \lambda), \qquad (153)$$

$$K_c = T = T' = \frac{\hbar\bar{E}_Q}{4(\Phi_0)^4}\frac{L_{eq}}{C_{eq}} = -\frac{3}{4}\frac{E_C}{\hbar}\frac{L}{\bar{L}_J}, \qquad (154)$$

with $E_C = e^2/(2C_{eq})$ the charging energy and $C_{eq} = C + 2\bar{C} + C_p$ the total capacitance. Note here that $C$ absorbs the contribution of $C_s$ for the sites $m = I, O$ that are also connected to extra input and output ports.

Without Quarton, one has $L_{eq} = \bar{L}_J/[2(\lambda + 1)]$, $\bar{E}_Q = \bar{E}_J$, and $\bar{L} = \bar{L}_J$, leading to

$$K_c = \frac{E_C}{\hbar}\frac{1}{\lambda+1}, \qquad (155)$$

$$K_s = \frac{E_C}{\hbar}. \qquad (156)$$

To have directional parameteric amplification in a device with standard JJ non-linearities one requires $\lambda > 0$,

implying $K_c < E_C/\hbar$, so the maximum achievable $K_c$ is restricted by $E_C$. On the other hand, $E_C$ is restricted by the low flux approximation, namely $\langle \phi_j^2 \rangle \ll \Phi_0^2$, which using Eq.(11) and $\langle \delta a_j^\dagger \delta a_j \rangle \ll |\alpha_{ss}^j|^2$ it can be translated to $|\alpha_{ss}^j|^2 \ll \hbar\widetilde{\omega}_b/(16E_C)$. Having a large bandwidth requires $g_c$ to be as large as possible in absolute frequency while respecting all other conditions to be in the directional amplification steady state. To have a large $g_c = Kc|\alpha|^2$, one requires either a large $K_c$ or large $|\alpha|^2$. However, the above two conditions restrict $K_c$ and $|\alpha|^2$ at the end limiting $g_c$. If $g_c$ is limited then all other quantities are limited and at the end also the bandwidth which is typically on order $\sim 2J \sim \kappa$. Explicitly, $g_c$ is restricted as

$$g_c = K_c|\alpha|^2 = \frac{1}{1+\lambda}\frac{E_C}{\hbar}|\alpha|^2 \ll \frac{1}{1+\lambda}\frac{\widetilde{\omega}_b}{16} < \frac{\widetilde{\omega}_b}{16}. \qquad (157)$$

Importantly, note that with the Quarton non-linearities it is possible to increase $K_c$ independently of $E_C$ via $L/\overline{L}_J$ so this restriction is lifted. The restriction on $|\alpha|^2$ remains, but one can still have a large $g_c \lesssim \widetilde{\omega}_b$, by having $L/\overline{L}_J \gg 1$, namely

$$|g_c| \ll \frac{3}{64}\left(\frac{L}{\overline{L}_J}\right)\widetilde{\omega}_b. \qquad (158)$$

This is the key advantage for using the Quarton configuration. In practice, $L$ will be given by $L = 1/(C_{eq}\widetilde{\omega}_b^2)$, where $C_{eq}$ is the total capacitance and $\widetilde{\omega}_b$ is chosen by the frequency of interest for amplification since $\omega_s \sim \omega_p \sim \widetilde{\omega}_b$. Then, given that value of $L$, the trick is to choose $\overline{L}_J \ll L$ which can always be done by having a large value of $\overline{E}_J$ within certain practical limits, for instance, $L_J = \overline{L}_J/(2\lambda) > 40$pH is standard to build with current technology.

**Other optional designs: Control of saturation via sub-array of non-linear inductances in series**

The non-linear behaviour of the device leads to saturation, i.e. that there is a limit in the maximum number of photon fluctuations that the device can tolarate when working as a linearized parametric amplifier array. However, it is possible to follow a standard procedure to reduce the effective non-linearity of the system while keeping the same linear properties of the circuit, i.e. without changing the linear inductances.

As sketched in Fig.11(c), the idea consists of replacing each on-site and inter-site non-linearity of the general form,

$$L_J^j = c_2(\Delta\phi_j)^2 + c_4(\Delta\phi_j)^4 + O(\Delta\phi_j^6), \qquad (159)$$

with $\Delta\phi_j$ the phase drop at site $j$, $c_2 \sim c_4 \sim E_J$ the linear and quartic non-linear contributions by $M$ identical non-linearities in series. The Josephson energies of these non-linearities must be $M$ times larger so that $c_2, c_4 \to Mc_2, Mc_4$, and the flux drop per element reduces to $\Delta\phi \to \Delta\phi/M$. Then, the effective Lagrangian at site $j$ reads,

$$L_{JJ}^j \to L_M^j = \sum_{i=1}^M Mc_2\left(\frac{\Delta\phi_j}{M}\right)^2 + Mc_4\left(\frac{\Delta\phi_j}{M}\right)^4 + O\left(\frac{\Delta\phi_j}{M}\right)^6 \qquad (160)$$

$$= c_2(\Delta\phi_j)^2 + \frac{c_4}{M^2}(\Delta\phi_j)^4 + O\left(\frac{\Delta\phi_j^6}{M^4}\right). \qquad (161)$$

Notice that the pre-factor $c_2$ of the linear response is unchanged (so the linear physics of the device is the same), but the quartic non-linearity is reduced by $M^2$, namely $c_4 \to c_4/M^2$.

Because of this, the limit of the mean number of photons per site increases by factor $M^2$ as well:

$$|\alpha|^2 \ll M^2\frac{\hbar\widetilde{\omega}_b}{16E_C}, \qquad (162)$$

with $E_C = e^2/(2C_{eq}^j)$ the charging energy, allowing the system to sustain an $M^2$ larger mean displacement $|\alpha|^2$ and

thereby reduce the fluctuations relative to the mean, $\langle \delta a_j^\dagger \delta a_j \rangle \ll |\alpha|^2$ . Since $K_c$ reduces by factor $M^2$ and $|\alpha|^2$ increases by the same factor $M^2$, the value of $g_c = K_c|\alpha|^2$ is unchanged by $M$. However, using sub-arrays of M Quarton non-linearities it is possible to control the saturation and increase the bandwidth by indepedently incresing $K_c$ as explained above.

## Claims

1. A method for stabilizing a non-linear parametric amplifier array for microwave radiation, wherein the amplifier array comprises:

   ▪ N non-linear resonator modes, wherein each mode, located at site $j = 1, \ldots, N$, is represented by a local complex amplitude ($a_j(t)$), and is **characterized by** a bare frequency ( $\omega_b^j$ ), a quartic self-Kerr anharmonicity ( $K_s^j$ ), and a local decay rate ($\kappa_j$),

   ▪ linear couplings placed between neighboring sites described by bare hopping rates ( $J_b^j$ ),

   ▪ non-linear couplings placed between neighboring sites described by quartic cross-Kerr interactions ( $K_c^j$ ), as well as by right- and left- photon-number-dependent hopping rates ($T_j$) and ($T_j'$), respectively,
   ▪ external coherent control fields on each site ($j$), wherein each control field drive each resonator applying a waveform with strength ( $\Omega_p^j$ ), frequency ( $\omega_p^j$ ), and phase ( $\theta_p^j$ );
   ▪ input/output ports placed at specific sites ($j = I$) and ($j = O$), configured to send a signal to amplify and to retrieve an amplified signal, respectively;

   the method comprising a step of finding suitable inhomogeneous profiles for the control fields: $\Omega_p^j, \omega_p^j, \theta_p^j$ and/or array parameters: $\omega_b^j, \kappa_j, J_b^j, K_s^j, K_c^j$ , $T_j$, $T_j'$, that give rise to a stable steady-state configuration of mean-field displacements, which means that $\langle a_j(t \to \infty) \rangle = \alpha_{ss}^j$ , and that is compatible with directional amplification of signals in the non-linear array, by:

   - setting the phases of the external coherent control fields to grow linearly with site index, as: $\theta_p^j = \varphi j$ with $\varphi \neq 0$ , so that time-reversal symmetry in the array is broken;
   - dividing the N sites of the array in 3 regions: left buffer region ($j \in [1, N_L]$), the central region ($j \in [N_L + 1, N_L + N_C]$), and right buffer region ($j \in [N - N_R + 1, N]$), such that $N = N_L + N_R + N_C$

   - setting, in the central region, $\omega_b^j = \omega_b^C, \kappa_j = \kappa_C, J_b^j = J_b^C, K_s^j = K_s^C, K_c^j = K_c^C$ , $T_j = T_C$, $T_j' = T_C'$, $\Omega_p^j = \Omega_p^C, \omega_p^j = \omega_p^C$ , being each one a constant central quantity, looking for an homogeneous steady-state solution $\langle a_j(t \to \infty) \rangle = \alpha_{ss}^C$ in this region, assuming periodic boundary conditions, and setting the

constant central quantities $\omega_b^C$, $\kappa_C$, $J_b^C, K_s^C, K_c^C$, $T_C$, $T_C'$, $\Omega_p^C, \omega_p^C$, such that there would be directional topological amplification in an homogenous system;
- In the left and right buffer regions, determining one or more quantities $Q_j$ selected from the control strengths $\Omega_p^j$, the linear array quantities $\kappa_j$, $J_b^j$ or all the non-linear couplings $K_s^j, K_c^j$, $T_j, T_j'$, and imposing for them a smoothly increasing or decreasing profile function from the boundaries $(Q_1, Q_N)$ to the locally homogeneous value at the central region $Q_C$ according to the relation,

$$\frac{Q_j}{Q_C} = f(j)$$

wherein the profile function $f(j)$ is positive and continuous for each j, tends to 1 in the central region and increases or decreases in the buffer regions;

- choosing the external coherent control frequencies $\omega_p^j$ or the bare resonator frequencies $\omega_b^j$ to locally compensate for the photon number-dependent frequency shifts induced by the non-linearities $K_s^j, K_c^j$, $T_j, T_j'$, such that the effective detuning $\Delta_j$ between pump frequency and shifted resonator frequencies is homogeneous or nearly homogenous $\Delta_j - \Delta_C$ along the array; and

- solving the exact steady-state mean-field displacements $\langle a_j(t \to \infty)\rangle = \alpha_{ss}^j$ assuming open boundary conditions of the non-linear array.

2. The method according to claim 1, wherein the step of solving the steady-state mean-field displacements $\alpha_j = \langle a_j(t)\rangle$ is determined by the non-linear system of equations in the rotating wave approximation, given by

$$\dot{\alpha}_j = -(\frac{\kappa_j}{2} - i\Delta_b^j)\alpha_j + \Omega_p^j e^{-i\theta_p^j} - i(J_b^j + T_j'|\alpha_j|^2 + \frac{T_j}{2}|\alpha_{j+1}|^2)\alpha_{j+1}$$

$$-i(J_b^{j-1} + T_{j-1}|\alpha_j|^2 + \frac{T_{j-1}'}{2}|\alpha_{j-1}|^2)\alpha_{j-1}$$

$$+iK_s^j|\alpha_j|^2\alpha_j + iK_c^j|\alpha_{j+1}|^2\alpha_j + iK_c^{j-1}|\alpha_{j-1}|^2\alpha_j$$

$$+i\frac{K_c^j}{2}\alpha_j^*\alpha_{j+1}^2 + i\frac{K_c^{j-1}}{2}\alpha_j^*\alpha_{j-1}^2 - i\frac{T_{j-1}}{2}\alpha_{j-1}^*\alpha_j^2 - i\frac{T_j'}{2}\alpha_{j+1}^*\alpha_j^2,$$

where $\Delta_b^j = \omega_p^j - \omega_b^j$ is the detuning between the pump frequency and the bare frequency of resonator at each site $j$.

3. The method according to claim 2, wherein the step of calculating the profiles of the pump frequencies $\omega_p^j$ or the bare resonator frequencies $\omega_b^j$ to locally compensate for the photon number-dependent shifts is obtained by the following steps:

- solving the differential equations of the step of step of solving the steady-state mean-field displacements, $\alpha_{ss}^j = \alpha_j(t \to \infty) = |\alpha_{ss}^j|e^{i\theta_{ss}^j}$ by setting $\dot{\alpha}_j = 0$ and imposing the condition that the bare detunings $\Delta_b^j$

relate to the effective detunings $\Delta_j = \omega_p^j - \omega_s^j$ between pump and shifted resonator frequencies $\omega_s^j$ as:

$$\Delta_b^j = \Delta_j - 2K_s^j |\alpha_{ss}^j|^2 - K_c^j |\alpha_{ss}^{j+1}|^2 - K_c^{j-1} |\alpha_{ss}^{j-1}|^2$$
$$+2|\alpha_{ss}^j| \cos(\varphi) \left[ T_{j-1} |\alpha_{ss}^{j-1}| + T_j' |\alpha_{ss}^{j+1}| \right].$$

the resulting system of algebraic non-linear equations being:

$$(\kappa_j/2 - i\Delta_j)|\alpha_{ss}^j| - 2i\cos(\varphi)|\alpha_{ss}^j|^2 (T_{j-1}|\alpha_{ss}^{j-1}| + T_j'|\alpha_{ss}^{j+1}|)$$

$$+2iK_s^j |\alpha_{ss}^j|^3 + iK_c^j |\alpha_{ss}^j||\alpha_{ss}^{j+1}|^2 + iK_c^{j-1}|\alpha_{ss}^j||\alpha_{ss}^{j-1}|^2$$

$$+ie^{-i\varphi}|\alpha_{ss}^{j+1}|(J_b^j + T_j'|\alpha_{ss}^j|^2 + \frac{T_j}{2}|\alpha_{ss}^{j+1}|^2)$$

$$+ie^{i\varphi}|\alpha_{ss}^{j-1}|(J_b^{j-1} + T_{j-1}|\alpha_{ss}^j|^2 + \frac{T_{j-1}'}{2}|\alpha_{ss}^{j-1}|^2)$$

$$-iK_s^j |\alpha_{ss}^j|^3 - iK_c^j |\alpha_{ss}^{j+1}|^2|\alpha_{ss}^j| - iK_c^{j-1}|\alpha_{ss}^{j-1}|^2|\alpha_{ss}^j|$$

$$-ie^{-2i\varphi}\frac{K_c^j}{2}|\alpha_{ss}^j||\alpha_{ss}^{j+1}|^2 - ie^{2i\varphi}\frac{K_c^{j-1}}{2}|\alpha_{ss}^j||\alpha_{ss}^{j-1}|^2$$

$$+ie^{-i\varphi}\frac{T_{j-1}}{2}|\alpha_{ss}^{j-1}||\alpha_{ss}^j|^2 + ie^{i\varphi}\frac{T_j'}{2}|\alpha_{ss}^{j+1}||\alpha_{ss}^j|^2 - \Omega_p^j = 0.$$

- setting the effective detuning $\Delta_j$ to be constant along the array, namely $\Delta_j = \Delta_C$, and solving the non-linear system of equations starting from the known locally homogeneous solution at the central region $|\alpha_{ss}^j| = |\alpha_{ss}^C|$, and iterating from there towards the boundaries, in the left buffer region, determining recursively $|\alpha_{ss}^{j-1}|$ given $|\alpha_{ss}^j|$ and $|\alpha_{ss}^{j+1}|$, whereas in the right buffer region, determining recursively $|\alpha_{ss}^{j+1}|$ given $|\alpha_{ss}^j|$ and $|\alpha_{ss}^{j-1}|$;

- using the resulting steady-state profile of the whole array to self-consistently determine the bare detuning $\Delta_b^j$ that leads to the effective constant detuning $\Delta_j = \Delta_C$, namely:

$$\Delta_b^j = \Delta_C - 2K_s^j |\alpha_{ss}^j|^2 - K_c^j |\alpha_{ss}^{j+1}|^2 - K_c^{j-1} |\alpha_{ss}^{j-1}|^2$$
$$+2|\alpha_{ss}^j| \cos(\varphi) \left[ T_{j-1} |\alpha_{ss}^{j-1}| + T_j' |\alpha_{ss}^{j+1}| \right].$$

- determining the inhomgenous profile of either $\omega_p^j$ or $\omega_b^j$ using $\Delta_b^j = \omega_p^j - \omega_b^j$ and taken the other as constant in the central region.

4. The method according to claim 3, wherein the step of calculating the steady-state displacement is simplified by

approximating $|\alpha_{ss}^{j\pm1}| \approx |\alpha_{ss}^{j}|$ so that the algebraic system of non-linear equations is reduced to $N$ independent third-order equations for $|\alpha_{ss}^{j}|^2$, which read:

$$|K_s^j + Z_j - Y_j|^2 |\alpha_{ss}|^6 + 2\left\{\left[\frac{\kappa_j}{2} - \Im(X_j)\right]\Im(Y_j)\right.$$

$$\left. - [\Delta_j - \Re(X_j)][K_s^j + Z_j - \Re(Y_j)]\right\}|\alpha_{ss}|^4$$

$$+ \left\{[\kappa_j/2 - \Im(X_j)]^2 + [\Delta_j - \Re(X_j)]^2\right\}|\alpha_{ss}|^2 - (\Omega_p^j)^2 = 0.$$

wherein the coefficients $X_j$, $Y_j$, and $Z_j$ are defined as:

$$X_j = J_b^j e^{-i\varphi} + J_b^{j-1} e^{i\varphi},$$

$$Y_j = K_c^j(1 + e^{-2i\varphi}/2) + K_c^{j-1}(1 + e^{2i\varphi}/2)$$

$$- T_j e^{-i\varphi}/2 - T_{j-1}' e^{i\varphi}/2$$

$$- T_{j-1}\left(e^{i\varphi} + \frac{e^{-i\varphi}}{2}\right) - T_j'\left(e^{-i\varphi} + \frac{e^{i\varphi}}{2}\right),$$

$$Z_j = K_c^j + K_c^{j-1} - 2\cos(\varphi)(T_j' + T_{j-1}).$$

**5.** The method according to any of claims 1 to 4, wherein in the step of imposing the relation between the quantities $Q_j$ calculated for the central region and the buffer regions, $f(j)$, the smoothly increasing function from the boundaries to the center: $Q_j = Q_C f(j)$ is chosen, and the decreasing function is the inverse of the same function: $Q_j = Q_C/f(j)$.

**6.** The method according to claim 5, wherein the function $f(j)$ is:

$$f(j) = \begin{cases} \sin^2\left(\frac{\pi}{2}\frac{j}{(N_L + 1)}\right), & \text{if } 1 \leq j \leq N_L \\ 1, & \text{if } N_L + 1 \leq j \leq N - N_R \\ \sin^2\left(\frac{\pi}{2}\frac{(N + 1 - j)}{(N_R + 1)}\right), & \text{if } N - N_R + 1 \leq j \leq N \end{cases}$$

with $N_L$, $N_R \sim 2$ or 3, $N_C \gg 1$.

**7.** The method according to claim 1, wherein in the step of determining the homogeneous parameters $\omega_b^C, \kappa_C, J_b^C, K_s^C, K_c^C$, $T_C$, $T_C'$, $\Omega_p^C$, $\omega_p^C$ in the central region so that they lead to directional parametric amplification are obtained by setting the following quantities: $\varphi = \pi/2$, $\Delta_C = 0$, $J_b^C = 0$, $T_C = T_C' = \frac{K_s^C}{2} = K_c^C$, $\omega_b^C = \omega_p^C + 6|\alpha_C|^2 K_c^C$, $K_c^C = \frac{\kappa_C}{4|\alpha_C|^2}$, with $\alpha_C$, $\kappa_C$, $\omega_p^C$ and $\Omega_p^C$ satisfying a standard 3rd order Duffing oscillator equation,

$$\left(\frac{\kappa_C}{2} - i\left[\left(\omega_p^C - \omega_b^C\right) + 3K_c^C|\alpha_c|^2\right]\right)\alpha_C = \Omega_p^C$$

.

8. A superconducting quantum parametric amplifier array of microwave radiation comprising:

- $N$ non-linear LC circuits, wherein each of them, located at site $j$ = 1, ..., $N$, comprises an on-site non-linear inductor of energy ( $E_J^j$ ), with linear inductance ( $L_J^j$ ) and quartic Kerr non-linearity, and an on-site capacitance $C_j$, both placed in parallel and connected to ground;
- Couplings, linear and non-linear couplings, between neighboring sites $j$ and $j$ + 1 comprising an inter-site capacitance $\overline{C}_j$ and an inter-site non-linear inductor of energy ( $\overline{E}_J^j$ ) with linear inductance ( $\overline{L}_J^j$ ) and quartic Kerr non-linearity, placed in parallel;
- external transmission lines connected via a capacitor $C_p^j$ to each node ($j$) configured to send coherent control fields;
- external transmission lines connected to specific sites ($j$ = $I$) and ($j$ = $O$), via capacitances $C_s^I$ and $C_s^O$, configured to send microwave signals and to retrieve the amplified signals, respectively,

wherein the control fields and/or the circuit parameters have inhomogeneous amplitudes, frequencies and/or phases obtained by the method according to any of claims 1 to 7.

9. The superconducting quantum parametric amplifier array according to claim 8, further comprising two additional non-linear inductors of energies ( $\overline{E}_J^0$ ) and ( $\overline{E}_J^N$ ), with linear inductances ( $\overline{L}_J^0$ ) and ( $\overline{L}_J^N$ ) and quartic Kerr non-linearities, coupled to sites ($j$ = 1) and ($j$ = $N$), as well as two additional capacitances ($\overline{C}_O$) and ($\overline{C}_N$), on parallel to the respective inductor, and connected to ground, to induce more homogeneous effective array parameters.

10. The superconducting quantum parametric amplifier array according to claims 8 and 9, wherein the on-site and inter-site non-linear inductors of energies ( $E_J^j$ ) and ( $\overline{E}_J^j$ ), respectively, are selected from an array of Josephson junctions or a kinetic inductance material, such that they lead to linear inductances ( $L_J^j$ ) and ( $\overline{L}_J^j$ ), and quartic Kerr non-linearities, to leading order in the energy-flux relation.

11. The superconducting quantum parametric amplifier array according to claim 10, wherein the on-site and inter-site non-linear inductors of energies ( $E_J^j$ ) and ( $\overline{E}_J^j$ ), respectively, are selected from: single Josephson junctions (JJ), SQUIDs, Quartons in parallel to a linear inductor, SNAILS, or a sub-array of any of the former non-linear inductive elements in series, such that they lead to linear inductances ( $L_J^j$ ) and ( $\overline{L}_J^j$ ), and quartic Kerr non-linearities, to leading order in the energy-flux relation.

12. The superconducting quantum parametric amplifier array according to claim 8, wherein the external transmission lines have an impedance ( $Z_p^j$ ) and comprise each one a voltage generator ( $V_p^j$ ) configured to generate the coherent control pump signals of strength ( $\Omega_p^j$ ), frequency ( $\omega_p^j$ ), and phase ( $\theta_p^j$ ).

13. The superconducting quantum parametric amplifier array according to claim 8, wherein the external transmission lines comprise an auxiliary waveguide comprising:

- $N$ linear LC circuits, wherein each of them, located at site $j = 1, ..., N$, comprises an on-site linear inductance ($L_w^j$) and an on-site capacitance $C_w^j$, both placed in parallel and connected to ground;

- linear auxiliary couplings between neighboring sites $j$ and $j + 1$ comprising an inter-site capacitance $\bar{C}_w^j$; and
- external auxiliary transmission lines connected to the boundary sites ($j = 1$) and ($j = N$), via auxiliary capacitances $C_{wp}^I$ and $C_{wp}^O$, configured to send a traveling coherent field at ($j = 1$) and to absorb at ($j = N$) without reflections by engineering perfect impedance matching conditions at the boundaries.

14. The superconducting quantum parametric amplifier array according to any of the claims 12 and 13, wherein the external transmission lines comprise voltage generators ($V_p^j$) connected to a first set of nodes (j), and the auxiliary waveguide connected to a second set of nodes (j).

15. The superconducting quantum parametric amplifier array according to any of the claims 8 to 14, wherein the local dissipation $\kappa_j$ of each non-linear LC circuit is realized either by the capacitor $C_p^j$ connected to each external transmission line or by on-chip resistors ($R_j$) placed in parallel to the on-site non-linear inductor of energy ($E_J^j$) and the on-site capacitance ($C_j$).

**FIG. 1**

**FIG 2.**

**FIG. 3**

**FIG. 4**

FIG. 5

FIG. 6

FIG. 7

FIG. 8

EP 4 622 104 A1

FIG. 9

FIG. 10

FIG. 11

Europäisches Patentamt
European Patent Office
Office européen des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TOM\'AS RAMOS ET AL: "Directional Josephson traveling-wave parametric amplifier via non-Hermitian topology", ARXIV.ORG, CORNELL UNIVERSITY LIBRARY, 201 OLIN LIBRARY CORNELL UNIVERSITY ITHACA, NY 14853, 4 August 2022 (2022-08-04), XP091287002, * abstract; figure 1 * | 1-15 | INV. H03F5/00 H03F19/00 |
| A | XIU GU ET AL: "Microwave photonics with superconducting quantum circuits", ARXIV.ORG, CORNELL UNIVERSITY LIBRARY, 201 OLIN LIBRARY CORNELL UNIVERSITY ITHACA, NY 14853, 7 July 2017 (2017-07-07), XP080775006, DOI: 10.1016/J.PHYSREP.2017.10.002 * page 68, paragraph 2 * | 1-15 | |

TECHNICAL FIELDS SEARCHED (IPC)

H03F

The present search report has been drawn up for all claims

| Place of search | Date of completion of the search | Examiner |
|---|---|---|
| The Hague | 6 August 2024 | Zakharian, Andre |

EPO FORM 1503 03.82 (P04C01)

**REFERENCES CITED IN THE DESCRIPTION**

**Non-patent literature cited in the description**

- **RAMOS, TOMÁS et al.** *Directional Josephson traveling-wave parametric amplifier via non-Hermitian topology.*

- **RAMOS et al.** *Tomás et al. Directional Josephson traveling-wave parametric amplifier via non-Hermitian topology.*